(19) Europäisches Patentamt
European Patent Office
Office européen des brevets

(11) **EP 1 182 464 B1**

(12) **EUROPÄISCHE PATENTSCHRIFT**

(45) Veröffentlichungstag und Bekanntmachung des Hinweises auf die Patenterteilung:
**28.09.2005 Patentblatt 2005/39**

(51) Int Cl.⁷: **G01R 33/3875**

(21) Anmeldenummer: **01115746.8**

(22) Anmeldetag: **09.07.2001**

(54) **Dimensionierung einer supraleitenden Shimvorrichtung in einer supraleitenden Magnetanordnung**

Dimensioning of a superconducting shim arrangement in a superconducting magnet arrangement

Dimensionnement d'un dispositif supraconducteur de shim dans un agencement supraconducteur d'aimants

(84) Benannte Vertragsstaaten:
**CH DE FR GB LI**

(30) Priorität: **24.08.2000 DE 10041683**

(43) Veröffentlichungstag der Anmeldung:
**27.02.2002 Patentblatt 2002/09**

(73) Patentinhaber: **Bruker BioSpin AG**
**8117 Fällanden (CH)**

(72) Erfinder:
- **Schauwecker, Robert**
  **8032 Zürich (CH)**
- **Bovier, Pierre-Alain**
  **8051 Zürich (CH)**
- **Amann, Andreas**
  **8008 Zürich (CH)**
- **Tschopp, Werner**
  **8127 Forch (CH)**

(74) Vertreter: **Kohler Schmid Möbus**
**Patentanwälte**
**Ruppmannstrasse 27**
**70565 Stuttgart (DE)**

(56) Entgegenhaltungen:
**US-A- 5 701 075**

- **GRANT D.M., HARRIS R.K., ED.: "Encyclopedia of Nuclear Magnetic Resonance" 1996 , JOHN WILEY & SONS , CHICHESTER XP002245037 * Seiten 1543-1547; Rayner D.L. et al: Cryogenic Magnets for Whole Body Magnetic Resonance Systems ***
- **ZHUKOVSKY A ET AL: "750 MHZ NMR MAGNET DEVELOPMENT *" IEEE TRANSACTIONS ON MAGNETICS, IEEE INC. NEW YORK, US, Bd. 28, Nr. 1, 1992, Seiten 644-647, XP000258062 ISSN: 0018-9464**

**Beschreibung**

Die Erfindung betrifft eine supraleitende Magnetanordnung zur Erzeugung eines Magnetfeldes in Richtung einer $z$-Achse in einem um $z = 0$ angeordneten Arbeitsvolumen mit einem Magnetspulensystem mit mindestens einer stromführenden supraleitenden Magnetspule, einer Shimvorrichtung mit mindestens einer supraleitenden Shimspule und gegebenenfalls mit einem oder mehreren zusätzlichen supraleitend geschlossenen Strompfaden, wobei die durch die zusätzlichen Strompfade im Betriebszustand aufgrund von induzierten Strömen erzeugten Magnetfelder in $z$-Richtung im Arbeitsvolumen die Größenordnung von 0.1 Tesla betragsmäßig nicht überschreiten, und wobei die Shimvorrichtung ein Feld erzeugt, welches entlang der $z$-Achse mit der $k$-ten Potenz von $z$ variiert für eine gerade Zahl $k$ größer 0.

Eine derartige supraleitende Magnetanordnung mit $Z^2$-Shimvorrichtung umfasst beispielsweise das von des Firma Bruker Magnetics vertriebene NMR Magnet System 600 SB UltraShield™ gemäß Firmenprospekt vom 15.05.1999.

Eine supraleitende Magnetanordnung mit einem aktiv abgeschirmten Magneten und zusätzlichen supraleitenden Strompfaden ohne $Z^2$-Shimvorrichtung ist bekannt aus der US-A 5,329,266.

Das Einsatzgebiet von supraleitenden Magneten umfasst verschiedene Anwendungsfelder, insbesondere die Magnetresonanzverfahren, in welchen in der Regel die örtliche Homogenität des Magnetfeldes wichtig ist. Zu den anspruchsvollsten Anwendungen gehört die hochauflösende KernresonanzSpektroskopie (NMR-Spektroskopie). Mit der geometrischen Anordnung der felderzeugenden Magnetspulen kann die Grundhomogenität des supraleitenden Magneten optimiert werden. Bei anspruchsvollen Anwendungen ist die Grundhomogenität des Magneten meistens ungenügend, weil beispielsweise Abweichungen vom Design aufgrund von Produktionsungenauigkeiten auftreten. Um Restinhomogenitäten des Magneten zu kompensieren, wird das Magnetsystem mit autonomen supraleitenden Spulen ausgerüstet, welche Feldinhomogenitäten mit einer bestimmten geometrischen Symmetrie im Arbeitsvolumen kompensieren können, sogenannten Shimvorrichtungen. Beispiele für solche Shimvorrichtungen sind sogenannte $Z^n$-Shims, welche ein Feld erzeugen, dessen Stärke entlang der Magnetachse $z$ proportional zu $z^n$ variiert. Der Schwerpunkt der Erfindung liegt auf dem Gebiet der Dimensionierung von supraleitenden $Z^n$-Shims in Magnetsystemen mit aktiver Streufeldabschirmung und zusätzlichen supraleitenden Strompfaden beispielsweise zur Kompensation von externen Feldstörungen.

Eine Anforderung an einen supraleitenden $Z^n$-Shim ist, dass sein Feldbeitrag im Arbeitsvolumen bei $z = 0$ unabhängig vom Strom in den Shimspulen im Wesentlichen null ist, und zwar unter Berücksichtigung der Feldbeiträge der Shimspulen selbst wie auch der Feldänderung aufgrund von Strömen, welche im supraleitenden Magneten und in weiteren supraleitend geschlossenen Strompfaden beim Laden der Shimvorrichtung induziert werden. Dimensioniert man einen $Z^n$-Shim nach einem gängigen Verfahren, wird man in gewissen Fällen feststellen, dass beim Laden der Shimvorrichtung eine unerwünschte Verschiebung der Magnetfeldstärke im Arbeitsvolumen bei $z = 0$ auftritt. In aktiv abgeschirmten Magneten ist dieses Verhalten insbesondere bei Shimvorrichtungen, deren Spulen auf verschiedene Radien verteilt sind, besonders deutlich. Der Grund dafür ist, dass in den gängigen Verfahren zur Dimensionierung supraleitender Shimvorrichtungen der Supraleiter als ein nichtmagnetisches Material behandelt wird. In der vorliegenden Erfindung wird demgegenüber zusätzlich berücksichtigt, dass sich der Supraleiter gegenüber Feldfluktuationen kleiner als 0.1 Tesla, wie sie auch beim Laden einer supraleitenden Shimvorrichtung im Magnetvolumen auftreten, im Wesentlichen als diamagnetisches Material verhält und somit kleine Feldfluktuationen weitgehend aus seinem Innern verdrängt. Dies manifestiert sich in einer Umverteilung des magnetischen Flusses der Feldfluktuationen in der Magnetanordnung, was sich wiederum darauf auswirkt, wie der supraleitende Magnet und weitere supraleitend geschlossene Strompfade auf eine Stromänderung in der Shimvorrichtung reagieren, weil diese Reaktion durch das Prinzip der Erhaltung des magnetischen Flusses durch eine geschlossene supraleitende Schlaufe bestimmt wird.

Aufgabe der vorliegenden Erfindung ist es demgegenüber, einen supraleitenden $Z^n$-Shim in einer Magnetanordnung der eingangs genannten Art mit möglichst einfachen Mitteln so zu modifizieren, dass die Shimvorrichtung unter Berücksichtigung des Diamagnetismus des Supraleiters korrekt dimensioniert ist, was insbesondere bedeutet, dass ihr Feldbeitrag im Arbeitsvolumen bei $z = 0$ unabhängig vom Strom in den Shimspulen im Wesentlichen null ist.

Erfindungsgemäß wird diese Aufgabe dadurch gelöst, dass die Shimvorrichtung derart ausgelegt sind, dass die Größe $g_S^{eff} = g_S - g^T \cdot (\underset{\leftarrow S}{L^{cl}} - \alpha L^{cor})^{-1} \cdot (\underset{\leftarrow S}{L^{cl}} - \alpha L^{cor})$ im Wesentlichen null ist. Dies jedoch nur dann, wenn die Größe $g_S^{eff,cl} = g_S - g^T \cdot (L^{cl})^{-1} \cdot \underset{\leftarrow S}{L^{cl}}$, welche resultieren würde, wenn $\alpha = 0$ wäre, betragsmäßig größer als null, insbesondere größer als 0.2 Millitesla pro Ampère, ist.

Die genannten Größen haben folgende Bedeutung:

$g_S^{eff}$:     Feldbeitrag pro Ampère Strom der Shimvorrichtung im Arbeitsvolumen bei $z = 0$ unter Berücksichtigung der Feldbeiträge der Shimspulen selbst wie auch der Feldänderung aufgrund von Strömen, welche im supraleitenden Magnetspulensystem und in den weiteren supraleitend geschlossenen Strompfaden beim Laden der Shimvorrichtung induziert werden,

$-\alpha$ :      mittlere magnetische Suszeptibilität im Volumen des Magnetspulensystems gegenüber Feldfluktuationen, welche die Größenordnung von 0.1 T betragsmäßig nicht überschreiten; wobei $0 < \alpha \leq 1$,

$$g^T = (g_M, g_{P1},..., g_{Pj},... g_{Pn}),$$

$g_{Pj}$ :      Feld pro Ampère des Strompfades $Pj$ im Arbeitsvolumen ohne die Feldbeiträge der Strompfade $Pi$ für $i \neq j$ und des Magnetspulensystems und ohne die Feldbeiträge der Shimvorrichtung ,

$g_M$ :      Feld pro Ampère des Magnetspulensystems im Arbeitsvolumen ohne die Feldbeiträge der zusätzlichen Strompfade und ohne die Feldbeiträge der Shimvorrichtung ,

$g_S$ :      Feld pro Ampère der Shimvorrichtung im Arbeitsvolumen ohne die Feldbeiträge der zusätzlichen Strompfade und des Magnetspulensystems ,

$L^{cl}$ :      Matrix der induktiven Kopplungen zwischen dem Magnetspulensystem und den zusätzlichen Strompfaden sowie zwischen den zusätzlichen Strompfaden untereinander,

$L^{cor}$ :      Korrektur zur Induktivitätsmatrix $L^{cl}$, welche sich bei kompletter diamagnetischer Verdrängung von Störfeldern aus dem Volumen des Magnetspulensystems ergäbe,

$L_{\leftarrow S}^{cl}$ :      Vektor der induktiven Kopplungen der Shimvorrichtung mit dem Magnetspulensystem und den zusätzlichen Strompfaden,

$L_{\leftarrow S}^{cor}$ :      Korrektur zum Kopplungsvektor $L_{\leftarrow S}^{cl}$ , welche sich bei kompletter diamagnetischer Verdrängung von Störfeldern aus dem Volumen des Magnetspulensystems ergäbe.

Einen $Z^n$-Shim nach dem Stand der Technik richtig zu dimensionieren bedeutet, dass die Feldeffizienzen $g_S$, $g_{P1},..., g_{Pn}$ und $g_M$ der Shimvorrichtung , der zusätzlichen supraleitenden Strompfade und des Magneten (jeweils ohne eine allfällige Reaktion der je anderen Komponenten zu berücksichtigen) sowie die induktiven Kopplungen der Shimvorrichtung, der zusätzlichen Strompfade und des Magneten untereinander sowie alle Selbstinduktivitäten richtig berechnet werden und die Shimvorrichtung so ausgelegt wird, dass die Größe $g_S^{eff,cl} = g_S - g^T \cdot (L^{cl})^{-1} \cdot L_{\leftarrow S}^{cl}$ im Wesentlichen null ist. In einer erfindungsgemäßen Anordnung wird dagegen bei der Dimensionierung der Shimvorrichtung berücksichtigt, dass zusätzlich zu den erwähnten Spuleneigenschaften ein magnetisches Abschirmverhalten des supraleitenden Volumenanteils im Magnetspulensystem auftritt. Aus diesem Grund wird die Shimvorrichtung so dimensioniert, dass statt der Größe $g_S^{eff,cl}$ die Größe $g_S^{eff} = g_S - g^T \cdot (L^{cl} - \alpha L^{cor})^{-1} \cdot (L_{\leftarrow S}^{cl} - \alpha L_{\leftarrow S}^{cor})$ im Wesentlichen null ist. Das erwähnte magnetische Abschirmverhalten des Supraleiters erscheint zwar in allen supraleitenden Magnetanordnungen, wirkt sich aber nur in gewissen Magnetanordnungen signifikant auf die Größe $g_S^{eff}$ aus. Der Vorteil der vorliegenden Erfindung besteht darin, dass die Anforderung an die Shimvorrichtung, dass $g_S^{eff}$ im Wesentlichen null ist, auch in solchen Magnetanordnungen erfüllt wird.

Die obengenannten Vorteile der Erfindung zahlen sich besonders in Systemen aus, in welchen die örtliche Homogenität des Magnetfeldes im Arbeitsvolumen besonders wichtig ist. Deshalb ist bei einer bevorzugten Ausführungsform die erfindungsgemäße Magnetanordnung Teil einer Apparatur zur hochauflösenden Magnetresonanz-Spektroskopie, beispielsweise auf dem Gebiet der NMR, ICR oder MRI.

Bei einer vorteilhaften Weiterbildung dieser Ausführungsform weist die Magnetresonanz-Apparatur eine Einrichtung zum Feldlock des im Arbeitsvolumen erzeugten Magnetfelds auf.

Bei einer anderen verbesserten Weiterbildung kann die Magnetanordnung auch Feldmodulations-Spulen aufweisen.

Besonders bevorzugt ist eine Ausführungsform der erfindungsgemäßen Magnetanordnung, bei der das supraleitende Magnetspulensystem ein radial inneres und ein radial äußeres, elektrisch in Serie zusammengeschaltetes, koaxiales Spulensystem umfasst, wobei diese beiden Spulensysteme im Arbeitsvolumen je ein Magnetfeld mit entgegengesetzter Richtung entlang der z-Achse erzeugen. In einer solchen Anordnung wirkt sich das magnetische Abschirmverhalten des Supraleiters im Magnetspulensystem typischerweise besonders stark auf die effektive Feldstärke im Arbeitsvolumen $g_S^{eff}$ gewisser Shimvorrichtungen aus.

Bei einer Weiterbildung dieser Ausführungsform weisen das radial innere Spulensystem und das radial äußere Spulensystem näherungsweise entgegengesetzt gleich große Dipolmomente auf. Dies ist die Bedingung für optimale Unterdrückung des Streufeldes des Magnetspulensystems. Aufgrund der großen technischen Bedeutung von aktiv abgeschirmten Magneten ist es ein großer Vorteil, dass Shimvorrichtungen in solchen Magneten richtig dimensioniert werden können, auch in jenen Fällen, wo sich das erwähnte magnetische Abschirmverhalten des Supraleiters im Magnetspulensystem signifikant in der effektiven Feldstärke im Arbeitsvolumen $g_S^{eff}$ der Shimvorrichtung niederschlägt.

Eine andere vorteilhafte Weiterbildung einer der obigen Ausführungsformen sieht vor, dass das Magnetspulensystem einen ersten im Betriebszustand supraleitend kurzgeschlossenen Strompfad bildet, und dass eine mit dem Magnetspulensystem galvanisch nicht verbundene Störkompensationsspule koaxial zum Magnetspulensystem angeordnet ist und einen weiteren im Betriebszustand supraleitend kurzgeschlossenen Strompfad bildet. Das Vorhandensein einer Störkompensationsspule verbessert die zeitliche Stabilität des Magnetfeldes im Arbeitsvolumen unter dem Einfluss von externen Feldfluktuationen. In einer solchen Weiterbildung einer erfindungsgemäßen Magnetanordnung wird der Einfluss einer Störkompensationsspule auf die effektive Feldstärke im Arbeitsvolumen $g_S^{eff}$ der Shimvorrichtung berücksichtigt.

Vorteilhaft ist auch eine Weiterbildung, die sich dadurch auszeichnet, dass mindestens einer der zusätzlichen Strompfade aus einem mit einem supraleitenden Schalter überbrückten Teil des Magnetspulensystems besteht. Mit einer solchen Anordnung wird die zeitliche Stabilität des Magnetfeldes im Arbeitsvolumen unter dem Einfluss von externen Feldfluktuationen verbessert. In einer solchen Weiterbildung einer erfindungsgemäßen Magnetanordnung wird der Einfluss der Überbrückung eines Teils des Magnetspulensystems mit einem supraleitenden Schalter auf die effektive Feldstärke im Arbeitsvolumen $g_S^{eff}$ der Shimvorrichtung berücksichtigt.

Bei einer vorteilhaften Weiterbildung der erfindungsgemäßen Magnetanordnung ist mindestens einer der zusätzlichen Strompfade Teil eines Systems zur Kompensation der Drift des Magnetspulensystems . Mit einer solchen Anordnung wird die zeitliche Stabilität des Magnetfeldes im Arbeitsvolumen verbessert. In einer solchen Weiterbildung einer erfindungsgemäßen Magnetanordnung wird der Einfluss der Driftkompensation auf die effektive Feldstärke im Arbeitsvolumen $g_S^{eff}$ der Shimvorrichtung berücksichtigt.

Vorteilhaft ist auch eine Weiterbildung, die sich dadurch auszeichnet, dass mindestens einer der zusätzlichen Strompfade aus einer weiteren supraleitenden Shimvorrichtung besteht. Mit einer solchen Anordnung können Feldinhomogenitäten, welche unterschiedliche Symmetrien aufweisen, kompensiert werden. In einer solchen Weiterbildung einer erfindungsgemäßen Magnetanordnung wird der Einfluss der zusätzlichen supraleitenden Shimvorrichtungen auf die effektive Feldstärke im Arbeitsvolumen $g_S^{eff}$ der ersten Shimvorrichtung berücksichtigt.

Eine besonders bevorzugte Ausführungsform der erfindungsgemäßen Magnetanordnung zeichnet sich dadurch aus, dass die supraleitende Shimvorrichtung ein Feld erzeugt, welches auf der *z*-Achse im Bereich des Arbeitsvolumens eine quadratische *z*-Abhängigkeit aufweist. Solche Shimvorrichtungen sind besonders wichtig, weil supraleitende Magnetspulensysteme häufig eine Feldinhomogenität aufweisen, welche auf der *z*-Achse im Bereich des Arbeitsvolumens eine quadratische *z*-Abhängigkeit aufweist.

Bei einer besonders vorteilhaften Weiterbildung dieser Magnetanordnung umfasst die supraleitende Shimvorrichtung Teilspulen, welche auf unterschiedlichen Radien gewickelt sind, um eine kompaktere Bauweise der Shimvorrichtung zu ermöglichen. In einer solchen Anordnung wirkt sich das magnetische Abschirmverhalten des Supraleiters im Magnetspulensystem typischerweise besonders stark auf die effektive Feldstärke im Arbeitsvolumen $g_S^{eff}$ der Shimvorrichtung aus.

Eine andere vorteilhafte Weiterbildung einer erfindungsgemäßen Magnetanordnung zeichnet sich dadurch aus, dass die supraleitende Shimvorrichtung vom supraleitenden Magnetspulensystem induktiv entkoppelt ist. Dies ist deshalb wichtig, weil so beim Laden oder bei einem Quench des supraleitenden Magnetspulensystems in der Shimvorrichtung keine hohen Ströme induziert werden.

Bei einer vorteilhaften Weiterbildung dieser Ausführungsform wird zur induktiven Entkopplung von Magnetspulensystem und Shimvorrichtung eine unterschiedliche Polarität des radial inneren und des radial äußeren Spulensystems ausgenutzt, falls das supraleitende Magnetspulensystem ein radial inneres und ein radial äußeres, elektrisch in Serie zusammengeschaltetes, koaxiales Spulensystem umfasst, wobei diese beiden Spulensysteme im Arbeitsvolumen je ein Magnetfeld mit entgegengesetzter Richtung entlang der z-Achse erzeugen. Die Nutzung der unterschiedlichen Polaritäten des radial inneren und des radial äußeren Spulensystems erleichtert das Design von Magnetanordnungen gemäß der oben beschriebenen Ausführungsform.

In den Rahmen der vorliegenden Erfindung fällt auch ein Verfahren zur Dimensionierung einer Shimvorrichtung , dadurch gekennzeichnet, dass die Größe $g_S^{eff}$, welche der Feldänderung im Arbeitsvolumen bei *z = 0* pro Ampere Strom in der Shimvorrichtung entspricht, unter Berücksichtigung der aufgrund von in der restlichen Magnetanordnung induzierten Strömen erzeugten Magnetfelder, berechnet wird gemäß:

$$g_S^{eff} = g_S - g^T \cdot (L^{cl} - \alpha L^{cor})^{-1} \cdot (L_{\leftarrow S}^{cl} - \alpha L_{\leftarrow S}^{cor}),$$

wobei die verwendeten Größen die oben genannten Bedeutungen haben. Der Vorteil dieser Methode zur Dimensionierung einer Shimvorrichtung besteht darin, dass das magnetische Abschirmverhalten des Supraleiters im Magnetspulensystem berücksichtigt wird. Mit dieser Methode können sämtliche Ausführungsformen der Erfindung dimensioniert werden, indem das Verhalten der Magnetanordnung beim Laden der Shimvorrichtung berechnet wird, unter Berücksichtigung der im Magnetspulensystem und in den zusätzlichen Strompfaden induzierten Stromänderungen. Die Methode basiert darauf, dass für die induktiven Kopplungen der zusätzlichen Strompfade untereinander, mit dem Magnetspulensystem und mit der Shimvorrichtung sowie für alle Selbstinduktivitäten Korrekturterme berechnet werden, welche sich mit einem Gewichtungsfaktor $\alpha$ auf die entsprechenden Größen niederschlagen. Mit dieser Methode wird eine bessere Übereinstimmung zwischen berechneter und messbarer effektiver Feldstärke im Arbeitsvolumen $g_S^{eff}$ der Shimvorrichtung erreicht als mit einer Methode nach dem Stand der Technik. Insbesondere kann erreicht werden, dass $g_S^{eff}$ im Wesentlichen null ist.

Bei einer einfachen Variante des erfindungsgemäßen Verfahrens entspricht der Parameter $\alpha$ dem Volumenanteil des Supraleitermaterials am Spulenvolumen des Magnetspulensystems. Dieser Methode zur Bestimmung des Parameters $\alpha$ liegt die Annahme zugrunde, dass im Supraleiter die Suszeptibilität gegenüber Feldfluktuationen (-1) betrage (idealer Diamagnetismus).

Die so bestimmten Werte für $\alpha$ können aber für die meisten Magnettypen experimentell nicht bestätigt werden. Daher zeichnet sich eine besonders bevorzugte alternative Verfahrensvariante dadurch aus, dass der Parameter $\alpha$ für das Magnetspulensystem experimentell bestimmt wird aus der Messung der Größe

$$\beta^{exp} = \frac{g_D^{exp}}{g_D}$$

des Magnetspulensystems, wobei keine zusätzlichen Strompfade vorhanden sind, bezüglich einer Störspule, welche im Volumen des Magnetspulensystems im Wesentlichen ein homogenes Störfeld erzeugt, und durch Einsetzen der Größe $\beta^{exp}$ in die Gleichung

$$\alpha = \frac{g_D (L_M^{cl})^2 (\beta^{exp} - \beta^{cl})}{g_D (\beta^{exp} - \beta^{cl}) L_M^{cl} L_M^{cor} - g_M (L_{M \leftarrow D}^{cl} L_M^{cor} - L_{M \leftarrow D}^{cor} L_M^{cl})} \, ,$$

wobei

$g_D^{exp}$ :    gemessene Feldänderung im Arbeitsvolumen der Magnetanordnung pro Ampère Strom in der Störspule,

$$\beta^{cl} = 1 - g_M \cdot \left( \frac{L_{M \leftarrow D}^{cl}}{L_M^{cl} \cdot g_D} \right) \, ,$$

$g_M$ :    Feld pro Ampère des Magnetspulensystems im Arbeitsvolumen,

$g_D$ :    Feld pro Ampere der Störspule im Arbeitsvolumen ohne die Feldbeiträge des Magnetspulensystems ,

$L_M^{cl}$ :    Induktivität des Magnetspulensystems ,

$L_{M \leftarrow D}^{cl}$ :    induktive Kopplung der Störspule mit dem Magnetspulensystem ,

$L_M^{cor}$ :    Korrektur zur Magnetinduktivität $L_M^{cl}$ , welche sich bei kompletter diamagnetischer Verdrängung von Störfeldern aus dem Volumen des Magnetspulensystems ergäbe,

$L_{M \leftarrow D}^{cor}$ :    Korrektur zur induktiven Kopplung $L_{M \leftarrow D}^{cl}$ der Störspule mit dem Magnetspulensystem , welche sich bei kompletter diamagnetischer Verdrängung von Störfeldern aus dem Volumen des Magnetspulensystems ergäbe.

Bei einer weiteren besonders bevorzugten Variante des erfindungsgemäßen Verfahrens schließlich werden die Korrekturen $L^{cor}$, $L_{\leftarrow S}^{cor}$, $L_M^{cor}$ und $L_{M \leftarrow S}^{cor}$ folgendermaßen berechnet:

$$L^{cor} = \begin{pmatrix} L_M^{cor} & L_{M \leftarrow P1}^{cor} & \cdots & L_{M \leftarrow Pn}^{cor} \\ L_{P1 \leftarrow M}^{cor} & L_{P1}^{cor} & \cdots & L_{P1 \leftarrow Pn}^{cor} \\ \vdots & \vdots & \ddots & \vdots \\ L_{Pn \leftarrow M}^{cor} & L_{Pn \leftarrow P1}^{cor} & \cdots & L_{Pn}^{cor} \end{pmatrix},$$

$$L_{\leftarrow S}^{cor} = \begin{pmatrix} L_{M \leftarrow S}^{cor} \\ L_{P1 \leftarrow S}^{cor} \\ \vdots \\ L_{Pn \leftarrow S}^{cor} \end{pmatrix},$$

$$L_{Pj \leftarrow Pk}^{cor} = f_{Pj}(L_{(Pj,\mathrm{red},Ra1) \leftarrow Pk}^{cl} - L_{(Pj,\mathrm{red},Ri_1) \leftarrow Pk}^{cl}),$$

$$L_{Pj \leftarrow S}^{cor} = f_{Pj}(L_{(Pj,\mathrm{red},Ra_1) \leftarrow S}^{cl} - L_{(Pj,\mathrm{red},Ri_1) \leftarrow S}^{cl}),$$

$$L_{Pj \leftarrow M}^{cor} = f_{Pj}(L_{(Pj,\mathrm{red},Ra_1) \leftarrow M}^{cl} - L_{(Pj,\mathrm{red},Ri_1) \leftarrow M}^{cl}),$$

$$L_{M \leftarrow Pj}^{cor} = L_{1 \leftarrow Pj}^{cl} - L_{(1,\mathrm{red},Ri_1) \leftarrow Pj}^{cl} + \frac{Ra_1}{R_2}(L_{(2,\mathrm{red},Ra_1) \leftarrow Pj}^{cl} - L_{(2,\mathrm{red},Ri_1) \leftarrow Pj}^{cl}),$$

$$L_{M \leftarrow S}^{cor} = L_{1 \leftarrow S}^{cl} - L_{(1,\mathrm{red},Ri1) \leftarrow S}^{cl} + \frac{Ra_1}{R_2}(L_{(2,\mathrm{red},Ra_1) \leftarrow S}^{cl} - L_{(2,\mathrm{red},Ri_1) \leftarrow S}^{cl}),$$

$$L_M^{cor} = L_{1 \leftarrow 1}^{cl} - L_{(1,\mathrm{red},Ri1) \leftarrow 1}^{cl} + L_{1 \leftarrow 2}^{cl} - L_{(1,\mathrm{red},Ri1) \leftarrow 2}^{cl}$$

$$+ \frac{Ra_1}{R_2}(L_{(2,\mathrm{red},Ra_1) \leftarrow 2}^{cl} - L_{(2,\mathrm{red},Ri_1) \leftarrow 2}^{cl} + L_{(2,\mathrm{red},Ra_1) \leftarrow 1}^{cl} - L_{(2,\mathrm{red},Ri_1) \leftarrow 1}^{cl})$$

wobei

$Ra_1$: Außenradius des Magnetspulensystems (im Falle eines aktiv abgeschirmten Magnetspulensystems Außenradius der Hauptspule),

$Ri_1$: Innenradius des Magnetspulensystems ,

$R_2$: im Falle eines aktiv abgeschirmten Magnetspulensystems mittlerer Radius der Abschirmung , sonst unendlich,

$R_{Pj}$: mittlerer Radius der Zusatzspule $Pj$,

$$f_{P_j} = \begin{cases} \dfrac{Ra_1}{R_{P_j}}, & R_{P_j} > Ra_1 \\ 1, & R_{P_j} < Ra_1 \end{cases}$$

und wobei der Index 1 im Falle eines aktiv abgeschirmten Magnetspulensystems die Hauptspule, sonst das Magnetspulensystem bezeichnet, der Index 2 im Falle eines aktiv abgeschirmten Magnetspulensystems die Abschirmung bezeichnet, während ansonsten die Terme mit Index 2 wegfallen, und der Index ($X$, $red$, $R$) eine hypothetische Spule bezeichnet, welche entstünde, wenn alle Windungen der Spule $X$ auf dem Radius $R$ gewickelt wären.

Der besondere Vorteil dieser Methode zur Berechnung der Korrekturen $L^{cor}$, $L^{cor}_{\leftarrow S}$, $L^{cor}_M$ und $L^{cor}_{M \leftarrow S}$ besteht darin, dass die Korrekturen unter Berücksichtigung der geometrischen Anordnung der beteiligten Spulen auf induktive Kopplungen und Eigeninduktivitäten von Spulen zurückgeführt werden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:

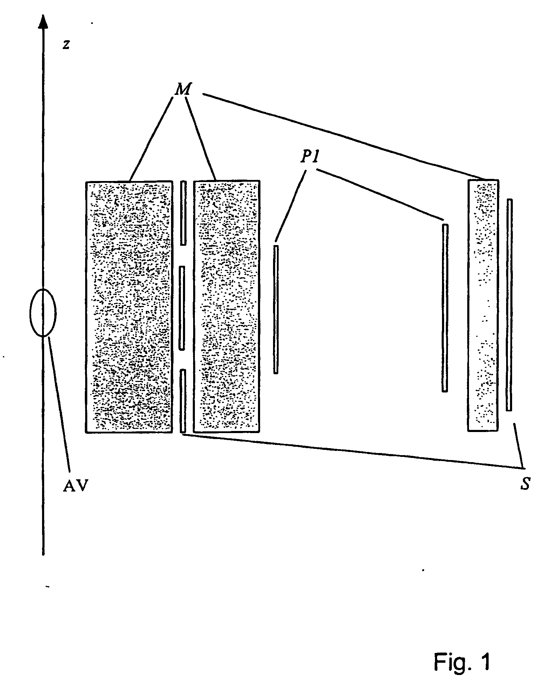

Fig. 1    einen schematischen Vertikalschnitt durch eine radiale Hälfte der erfindungsgemäßen Magnetanordnung zur Erzeugung eines Magnetfeldes in Richtung einer $z$-Achse in einem um $z = 0$ angeordneten Arbeitsvolumen $AV$ mit einem Magnetspulensystem $M$, einer Shimvorrichtung $S$ und mit einem zusätzlichen supraleitend geschlossenen Strompfad $P1$;

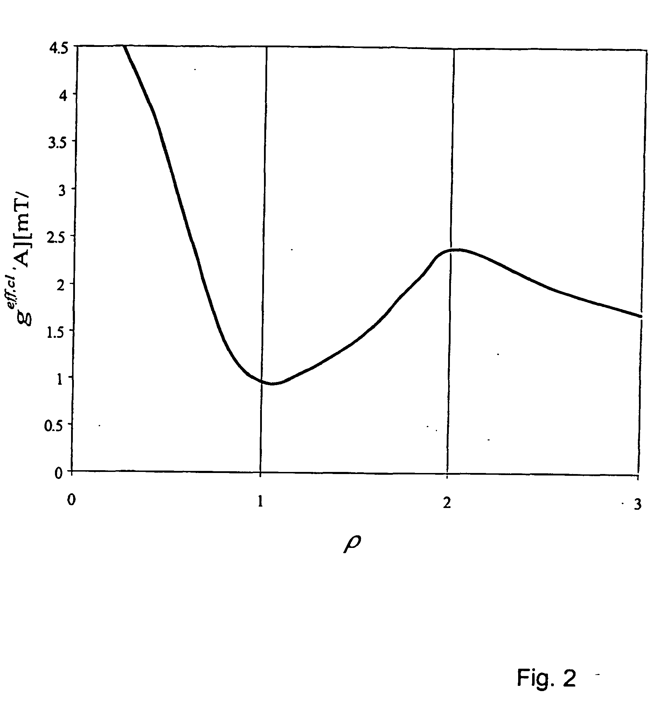

Fig. 2    die effektive Feldstärke $g^{eff,cl}$ pro Ampère Strom, berechnet mit einer Methode nach dem Stand der Technik, für eine einzelne Teilspule einer Shimvorrichtung in einem aktiv abgeschirmten supraleitenden Magnetspulensystem ohne zusätzliche Strompfade als Funktion des reduzierten Radius $\rho$ (Radius normiert auf den Außenradius der Hauptspule des Magnetspulensystems) der betrachteten Teilspule;

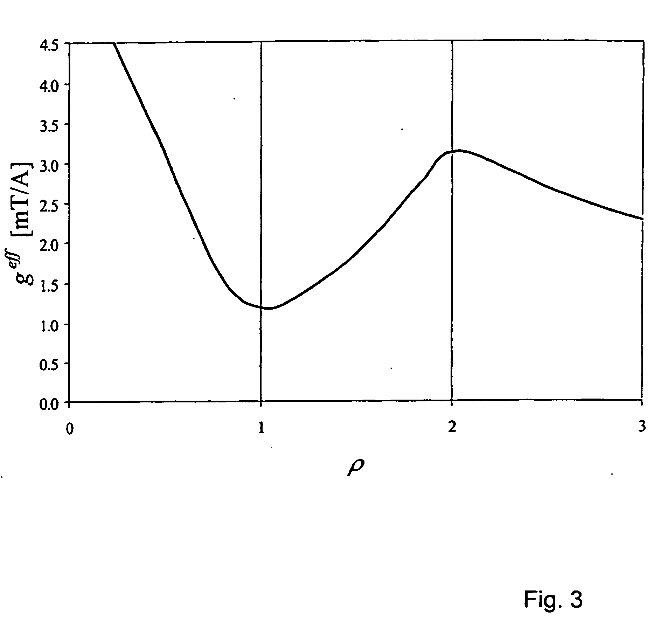

Fig. 3    die effektive Feldstärke $g^{eff}$ pro Ampère Strom, berechnet mit der erfindungsgemäßen Methode, für eine einzelne Teilspule einer Shimvorrichtung in einem aktiv abgeschirmten supraleitenden Magnetspulensystem ohne zusätzliche Strompfade als Funktion des reduzierten Radius $\rho$ (Radius normiert auf den Außenradius der Hauptspule des Magnetspulensystems) der betrachteten Teilspule;

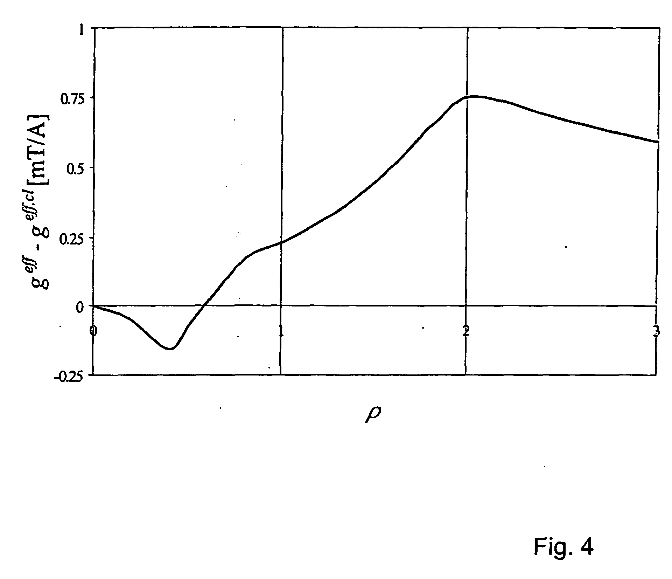

Fig. 4    die Differenz der in Figur 2 und 3 dargestellten Größen $g^{eff}$ und $g^{eff,cl}$ als Funktion des reduzierten Radius $\rho$ (Radius normiert auf den Außenradius der Hauptspule) der betrachteten Teilspule.

Anhand der Figur 1 wird ersichtlich, dass in einer erfindungsgemäßen Magnetanordnung sowohl das supraleitende Magnetspulensystem $M$ als auch die Shimvorrichtung $S$ und der zusätzliche Strompfad $P1$ aus mehreren Teilspulen aufgebaut sein können, welche auf verschiedene Radien verteilt sein können. Die Teilspulen können unterschiedliche Polaritäten aufweisen. Alle Teilspulen sind koaxial angeordnet um ein Arbeitsvolumen $AV$ auf einer Achse $z$ bei $z = 0$. Durch den kleinen Spulenquerschnitt der Shimvorrichtung $S$ und der Zusatzspule $P1$ in der Figur 1 wird dargestellt, dass die Shimvorrichtung $S$ und die Zusatzspulen $P1$ nur schwache Magnetfelder erzeugen, das Hauptfeld aber vom Magnetspulensystem $M$ herrührt.

Anhand der Figuren 2 bis 4 werden die Funktionen $g^{eff,cl}$ und $g^{eff}$ für eine einzelne Teilspule einer Shimvorrichtung gezeigt in Abhängigkeit vom Radius der Teilspule. Die Teilspule hat eine axiale Länge von 200 mm und besteht aus zwei Lagen mit je 400 Drahtwindungen. Ihre Mittelebene liegt auf der Höhe des Arbeitsvolumens bei $z = 0$. Die Größen $g^{eff,cl}$ beziehungsweise $g^{eff}$ entsprechen dem Feldbeitrag pro Ampère der betrachteten Teilspule im Arbeitsvolumen bei $z = 0$ unter Berücksichtigung der Feldbeiträge der Teilspule selbst wie auch der Feldänderung aufgrund von Strömen, welche im supraleitenden Magnetspulensystem $M$ beim Laden der Teilspule induziert werden, wobei $g^{eff,cl}$ mit einer Methode nach dem Stand der Technik und $g^{eff}$ mit der erfindungsgemäßen Methode simuliert wurde. Diese Berechnungen wurden für eine Magnetanordnung mit einem aktiv abgeschirmten supraleitenden Magnetspulensystem $M$ ohne zusätzliche supraleitende Strompfade durchgeführt, wobei der Radius der aktiven Abschirmung dem doppelten Außenradius der Hauptspule des Magnetspulensystems $M$ entspricht. Die Dipolmomente von Hauptspule und Abschirmspule sind entgegengesetzt gleich groß. Es zeigt sich, dass sich aufgrund der mit $\alpha = 0.33$ gewich-

teten Korrekturterme entsprechend der erfindungsgemäßen Methode gegenüber einer Methode nach dem Stand der Technik für große Radien der Teilspule der Shimvorrichtung eine Abweichung von etwa 40 Prozent ergibt für die effektive Feldstärke pro Ampere. Die Größe $\alpha = 0.33$ entspricht grob dem Supraleitergehalt des Spulenvolumens des Magnetspulensystems.

Um die nachfolgende Beschreibung zu vereinfachen, werden hier einige Begriffe eingeführt:

- Ein aktiv abgeschirmtes supraleitendes Magnetspulensystem *M* umfasst ein radial inneres Spulensystem *C1*, im Weiteren als *Hauptspule* bezeichnet, und ein radial äußeres Spulensystem *C2*, im Folgenden *Abschirmspule* genannt. Diese Spulen sind axialsymmetrisch um eine *z*-Achse angeordnet und erzeugen in einem auf der Achse um *z* = 0 angeordneten Volumen - im Folgenden als das *Arbeitsvolumen* des Magneten bezeichnet - Magnetfelder entgegengesetzter Richtung. Ein nicht abgeschirmtes supraleitendes Magnetspulensystem *M* wird als Spezialfall mit einem vernachlässigbaren äußeren Spulensystem *C2* betrachtet.

- Unter einem *Störfeld* verstehen wir entweder eine elektromagnetische Störung, die außerhalb der Magnetanordnung entsteht oder ein Feld, das von zusätzlichen, nicht zum Magnetspulensystem *M* gehörenden, Spulen erzeugt wird (beispielsweise von Spulen einer Shimvorrichtung) und dessen Feldbetrag 0.1 T nicht überschreitet.

- Um möglichst kompakte und übersichtliche Formeln zu bekommen, werden in der Ausführung folgende Indizes benutzt:

  1      Hauptspule
  2      Abschirmspule
  *M*     Magnetspulensystem *C1*, *C2*
  *S*     Shimvorrichtung
  *D*     Störung ("disturbance")
  *P*     zusätzlicher supraleitender Strompfad
  *cl*    Nach dem zitierten Stand der Technik berechnete Größe
  *cor*   Korrekturterme gemäß der vorliegenden Erfindung

Für zusätzliche supraleitende Strompfade werden die Indizes *P1*, *P2*, ... verwendet.

Bei der Berechnung der effektiven Feldstärke $g^{eff}$ pro Ampère Strom einer Shimvorrichtung müssen sowohl die Feldbeiträge der Shimspulen selbst wie auch die Feldänderungen aufgrund von Strömen, welche im supraleitenden Magnetspulensystem und in weiteren supraleitend geschlossenen Strompfaden beim Laden der Shimvorrichtung induziert werden, berücksichtigt werden. Um die induktive Reaktion des Magnetspulensystems mit einem Modell nach dem Stand der Technik (im Weiteren als das *klassische Modell* bezeichnet) zu berechnen, wird der Supraleiter des Magnetspulensystems als ein Material ohne elektrischen Widerstand modelliert. Im Modell, welches der vorliegenden Erfindung zugrunde liegt, werden dagegen zusätzliche magnetische Eigenschaften des Supraleiters berücksichtigt. Diese Eigenschaften haben zwar alle supraleitenden Magnetspulensysteme, sie wirken sich aber vor allem in aktiv abgeschirmten Magnetspulensystemen auf die effektive Feldstärke von zusätzlichen Spulensystemen (beispielsweise Shimvorrichtungen) in der Magnetanordnung aus, insbesondere dann, wenn die zusätzlichen Spulensysteme Teilspulen umfassen, welche auf verschiedene Radien verteilt sind. In solchen Magnetanordnungen stellt man häufig fest, dass die gemessene effektive Feldstärke des zusätzlichen Spulensystems (beispielsweise einer Shimvorrichtung) nicht der mit dem klassischen Modell berechneten entspricht. Insbesondere wirkt sich dies dahingehend aus, dass Shimvorrichtungen im Arbeitsvolumen einen unerwünschten Feldbeitrag leisten, wenn sie mit einer Methode nach dem klassischen Modell dimensioniert wurden.

Weil das Feld des supraleitenden Magnetspulensystems im Arbeitsvolumen um Größenordnungen stärker ist als das Feld von zusätzlichen Spulensystemen (beispielsweise einer Shimvorrichtung), wirkt sich nur die zum Feld des Magnetspulensystems parallele Komponente (hier als *z*-Komponente bezeichnet) des Feldes der zusätzlichen Spulensysteme im Gesamtfeldbetrag aus. Deshalb betrachten wir im Weiteren nur $B_z$-Felder.

Sobald am Ort eines supraleitenden Magnetspulensystems *M* durch eine Störspule *D* ein Störfeld aufgebaut wird (beispielsweise beim Laden einer Shimvorrichtung), wird nach der Lenz'schen Regel ein Strom im supraleitend kurzgeschlossenen Magnetspulensystem induziert, welcher ein dem Störfeld entgegengesetztes Kompensationsfeld aufbaut. Die im Arbeitsvolumen resultierende Feldänderung $\Delta B_{z,total}$ ist eine Überlagerung des Störfeldes $\Delta B_{z,D}$ und des Kompensationsfeldes $\Delta B_{z,M}$, das heißt $\Delta B_{z,total} = \Delta B_{z,D} + \Delta B_{z,M}$. Bei einem Strom $\Delta I_D$ in der Störspule *D* wird im

Magnetspulensystem der Strom $\Delta I^{cl}_M = -\Delta I_D \cdot \dfrac{L^{cl}_{M \leftarrow D}}{L^{cl}_M}$ induziert, wobei $L^{cl}_M$ die (klassische) Eigeninduktivität des Magnet-

spulensystems und $L_{M\leftarrow D}^{cl}$ die (klassische) induktive Kopplung zwischen Magnetspulensystem und Störspule bedeuten. Die effektive Feldstärke pro Ampère Strom in der Störspule $D$ im Arbeitsvotumen $g_D^{eff,cl} = \frac{\Delta B_{z,total}}{\Delta I_D}$ ist die Überlagerung des Feldbeitrags pro Ampère $g_D = \frac{\Delta B_{z,D}}{\Delta I_D}$ der Störspule selbst mit der Feldänderung aufgrund des im supraleitenden Magnetspulensystem $M$ pro Ampère Störstrom induzierten Stromes, also:

$$g\frac{eff,cl}{D} = g_D + g_M \frac{\Delta I_M^{cl}}{\Delta I_D} = g_D - g_M \frac{L_{M\leftarrow D}^{cl}}{L_M^{cl}} \,, \qquad (1)$$

wobei $g_M$ das Feld pro Ampere des Magnetspulensystems $M$ im Arbeitsvolumen ist.

Im Fall, wo in der Magnetanordnung nebst dem Magnetspulensystem $M$ und einer Störspule $D$ (beispielsweise einer Shimvorrichtung) noch weitere supraleitend kurzgeschlossene Strompfade $P1,...,Pn$ vorhanden sind, verallgemeinert sich die obige Formel zu:

$$g_D^{eff,cl} = g_D - g^T \cdot (L^{cl})^{-1} \cdot L_{\leftarrow D}^{cl}, \qquad (2)$$

wobei:

$$g^T = (g_M, g_{P1},...,g_{Pj},...,g_{Pn}),$$

wobei:

$g_M$ :      Feld pro Ampère des Magnetspulensystems $M$ im Arbeitsvolumen ohne die Feldbeiträge der in den zusätzlichen Strompfaden $P1,...,Pn$ induzierten Ströme,

$g_{Pj}$:      Feld pro Ampère des Strompfades $Pj$ im Arbeitsvolumen ohne die Feldbeiträge der in den anderen zusätzlichen Strompfaden $P1,...,Pn$ und im Magnetspulensystem $M$ induzierten Ströme,

$$L^{cl} = \begin{pmatrix} L_M^{cl} & L_{M\leftarrow P1}^{cl} & \cdots & L_{M\leftarrow Pn}^{cl} \\ L_{P1\leftarrow M}^{cl} & L_{P1}^{cl} & \cdots & L_{P1\leftarrow Pn}^{cl} \\ \vdots & \vdots & \ddots & \vdots \\ L_{Pn\leftarrow M}^{cl} & L_{Pn\leftarrow P1}^{cl} & \cdots & L_{Pn}^{cl} \end{pmatrix}$$

     Matrix der (klassischen) induktiven Kopplungen zwischen dem Magnetspulensystem $M$ und den Strompfaden $P1,...,Pn$ sowie zwischen den Strompfaden $P1,...,Pn$ untereinander,

$(L^{cl})^{-1}$      Inverse der Matrix $L^{cl}$,

$$L_{\leftarrow D}^{cl} = \begin{pmatrix} L_{M\leftarrow D}^{cl} \\ L_{P1\leftarrow D}^{cl} \\ \vdots \\ L_{Pn\leftarrow D}^{cl} \end{pmatrix},$$

     wobei:

$L_{Pj\leftarrow D}^{cl}$      (klassische) induktive Kopplung des Strompfades $Pj$ mit der Spule $D$,

$L_{M \leftarrow D}^{cl}$  (klassische) induktive Kopplung des Magnetspulensystems $M$ mit der Spule $D$.

Um die Feldeffizienz $g_S^{eff,cl}$ einer supraleitenden Shimvorrichtung $S$ zu berechnen, kann die oben hergeleitete Formel für $g_D^{eff,cl}$ einer beliebigen Störspule $D$ benutzt werden, wobei an Stelle der Kopplungen des Magnetspulensystems $M$ und der zusätzlichen supraleitenden Strompfade $P1,...,Pn$ mit der Störspule $D$ jeweils die Kopplungen mit der Shimvorrichtung $S$ einzusetzen sind.

Unter Berücksichtigung der erwähnten speziellen magnetischen Eigenschaften des Supraleiters werden die klassischen induktiven Kopplungen und die Eigeninduktivitäten um einen zusätzlichen Beitrag erweitert. Deshalb werden die im Magnetspulensystem $M$ und in den zusätzlichen Strompfaden $P1,...,Pn$ induzierten Ströme im Allgemeinen andere Werte als die klassisch berechneten annehmen. Im Folgenden werden diese Korrekturen aufgrund eines Modelles des magnetischen Verhaltens des Supraleiters im Magnetspulensystem berechnet.

Es ist bekannt, dass Typ-I Supraleiter magnetischen Fluss komplett aus ihrem Inneren verdrängen (Meissner Effekt). Bei Typ-II Supraleitern ist dies oberhalb des unteren kritischen Feldes $H_{c1}$ nicht mehr der Fall. Nach dem Bean-Modell (C.P. Bean, Phys. Rev. Lett. **8,** 250 (1962), C.P. Bean, Rev. Mod. Phys. **36,** 31 (1964)) haften die magnetischen Flusslinien aber an den sogenannten "pinning centers". Kleine Flussänderungen werden von den "pinning centers" an der Oberfläche des Supraleiters eingefangen und gelangen nicht bis ins Innere des Supraleiters. Es resultiert eine teilweise Verdrängung von Störfeldern aus dem Supraleitervolumen. Ein Typ-II Supraleiter reagiert also auf kleine Feldfluktuationen diamagnetisch, während größere Feldänderungen weitgehend ins Supraleitermaterial eindringen.

Um die Wirkungen dieses Effekts der Verdrängung von kleinen Störfeldern aus dem Supraleitervolumen berechnen zu können, machen wir verschiedene Annahmen. Erstens gehen wir davon aus, dass der überwiegende Anteil des gesamten Supraleitervolumens in einer Magnetanordnung in der Hauptspule konzentriert ist, und dass das Supraleitervolumen in der Abschirmspule und in weiteren supraleitenden Spulensystemen vernachlässigt werden kann.

Ferner stellen wir uns vor, dass alle Feldfluktuationen im Volumen der Hauptspule um einen konstanten Faktor $(1 - \alpha)$ mit $0 < \alpha < 1$ reduziert sind gegenüber dem Wert, den sie ohne die diamagnetische Abschirmwirkung des Supraleiters hätten. In der freien Innenbohrung der Hauptspule (Radius $Ri_1$) nehmen wir dagegen an, dass keine Reduktion der Störfelder aufgrund des Supraleiter-Diamagnetismus auftritt. Die aus der Hauptspule verdrängten Feldlinien akkumulieren sich außerhalb des Außenradius $Ra_1$ der Hauptspule, so dass in diesem Bereich eine Überhöhung des Störfeldes eintritt. Für diese Störfeldüberhöhung außerhalb von $Ra_1$ nehmen wir an, dass sie von einem Maximalwert bei $Ra_1$ gegen größere Abstände $r$ von der Magnetachse mit $(1/r^3)$ abnehme (Dipolverhalten). Der Maximalwert bei $Ra_1$ wird so normiert, dass die Verstärkung des Störflusses außerhalb $Ra_1$ die Reduktion des Störflusses innerhalb des Supraleitervolumens der Hauptspule genau kompensiert (Flusserhaltung).

Die Umverteilung von magnetischem Fluss durch die Anwesenheit eines sich gegenüber kleinen Feldfluktuationen diamagnetisch verhaltenden Supraleitervolumens bewirkt, dass die induktiven Kopplungen und Eigeninduktivitäten von Spulen im Bereich des Supraleitervolumens verändert werden. Um das klassische Modell zur Berechnung der effektiven Feldstärke einer Störspule $D$ (beispielsweise einer Teilspule einer Shimvorrichtung) zu erweitern und den Einfluss des Supraleiter-Diamagnetismus zu berücksichtigen, genügt es, für jeden in der Formel $g_D^{eff,cl} = g_D - g^T \cdot (L^{cl})^{-1} \cdot L_{\leftarrow D}^{cl}$ vorkommenden Kopplungs- oder Eigeninduktivitäts-Term den richtigen Korrekturterm zu bestimmen. An der Struktur der Gleichung ändert sich nichts. Die Korrekturterme werden im Folgenden für alle Kopplungen und Eigeninduktivitäten hergeleitet.

Das Prinzip der Berechnung der Korrekturterme ist in allen Fällen dasselbe, nämlich zu bestimmen, um wie viel der magnetische Fluss durch eine Spule aufgrund einer kleinen Stromänderung in einer anderen (oder in ihr selbst) durch die Anwesenheit des diamagnetisch reagierenden Supraleitermaterials in der Hauptspule des Magnetspulensystems reduziert wird. Entsprechend ist auch die Kopplung der ersten mit der zweiten Spule (bzw. die Eigeninduktivität) reduziert. Die Größe des Korrekturterms hängt einerseits davon ab, wie groß der Anteil des mit Supraleitermaterial der Hauptspule gefüllten Volumens innerhalb der induktiv reagierenden Spule am gesamten von der Spule umschlossenen Volumen ist. Andererseits hat auch die relative Lage der Spulen zueinander einen Einfluss auf den Korrekturterm für ihre gegenseitige induktive Kopplung.

Als nützliches Hilfsmittel zur Berechnung der Korrekturterme hat sich die Einführung von "reduzierten Spulen" erwiesen. Unter der auf den Radius $R$ reduzierten Spule $X$ verstehen wir jene hypothetische Spule, welche entstünde, wenn alle Windungen der Spule $X$ auf dem Radius $R$ gewickelt wären. Für diese Spule wird in der Notation der Index *"X,red,R"* verwendet. Dank der reduzierten Spulen können bei einer Flussänderung durch eine Spule die Beiträge der Flussänderung durch Teilflächen dieser Spule an der gesamten Flussänderung berechnet werden.

Als erstes wird nun der Korrekturterm für die Kopplung einer Störspule $D$ mit der Hauptspule $C1$ des Magnetspulensystems (abgeschirmt oder unabgeschirmt) berechnet.

Im Volumen der Hauptspule $C1$ wird das Störfeld $\Delta B_{z,D}$ im Mittel um den Beitrag $\alpha \cdot \Delta B_{z,D}$ reduziert, wobei $0 < \alpha < 1$ ein a priori noch unbekannter Parameter ist. Als Konsequenz wird der Störfluss durch die Hauptspule $C1$ und damit die induktive Kopplung $L_{1\leftarrow D}$ von Hauptspule und Störquelle um einen Faktor $(1 - \alpha)$ gegenüber dem klassischen Wert $L_{1\leftarrow D}^{cl}$ geschwächt, sofern man das Störfeld in der Innenbohrung der Hauptspule auch als um den Faktor $(1 - \alpha)$ reduziert behandelt. Wir nehmen aber an, dass der Fluss der Störung nicht aus der Innenbohrung des Magneten verdrängt wird. Daher muss die Kopplung zwischen Störung und Hauptspule nun wieder um den fälschlicherweise abgezogenen Anteil aus der Innenbohrung ergänzt werden. Gemäß der Definition der "reduzierten Spulen" ist dieser Beitrag $\alpha \cdot L_{(1,\mathrm{red},Ri1)\leftarrow D}^{cl}$, wobei $L_{(1,\mathrm{red},Ri1)\leftarrow D}^{cl}$ die Kopplung der Störung mit der auf ihren Innenradius $Ri_1$ reduzierten Hauptspule $C1$ ist. Unter Berücksichtigung der Störfeldverdrängung aus dem Supraleitervolumen der Hauptspule beträgt die induktive Kopplung $L_{1\leftarrow D}$ von Hauptspule und Störquelle daher:

$$L_{1\leftarrow D} = (1 - \alpha) \cdot L_{1\leftarrow D}^{cl} + \alpha L_{(1,\mathrm{red},Ri1)\leftarrow D}^{cl} \tag{3}$$

Der verdrängte Fluss taucht radial außerhalb des Außenradius $Ra_1$ der Hauptspule wieder auf. Nimmt man für das verdrängte Feld ein Dipolverhalten an (Abnahme mit $(1 / r^3)$), bekommt man außerhalb der Hauptspule zusätzlich zum klassischen Störfeld noch den Beitrag

$$\alpha \frac{Ra_1}{r^3} \int_{Ri_1}^{Ra_1} \Delta B_{z,D} R dR. \tag{4}$$

Diese Funktion ist so normiert, dass der gesamte Fluss der Störung durch eine große Schlaufe vom Radius $R$ für $R \rightarrow \infty$ gegen null strebt. Es wurde ein Störfeld $\Delta B_{z,D}$ mit Zylindersymmetrie angenommen.
Im Falle eines aktiv abgeschirmten Magnetspulensystems reduziert sich wegen der Verdrängung des Störflusses durch die Hauptspule $C1$ auch der Störfluss durch die Abschirmspule $C2$. Genauer gesagt ist der Störfluss durch eine Windung vom Radius $R_2$ auf axialer Höhe $z_0$ gegenüber dem klassischen Fall um folgenden Beitrag reduziert (Integral von (4) über das Gebiet $r > R_2$):

$$2\pi\alpha \int_{R_2}^{\infty} \frac{Ra_1}{r^2} dr \int_{Ri_1}^{Ra_1} \Delta B_z^D R dR = 2\pi\alpha \frac{Ra_1}{R_2} \int_{Ri_1}^{Ra_1} \Delta B_z^D R dR = \alpha \frac{Ra_1}{R_2} (\Phi_{(2,\mathrm{red},Ra_1)\leftarrow D}^{cl} - \Phi_{(2,\mathrm{red},Ri_1)\leftarrow D}^{cl})$$

$\Phi_{(2,\mathrm{red},Ra_1)\leftarrow D}^{cl}$ bezeichnet hier den klassischen Störfluss durch eine Schlaufe vom Radius $Ra_1$, die sich auf gleicher axialer Höhe $z_0$ befindet wie die betrachtete Schlaufe mit Radius $R_2$ (analog für $Ri_1$). Summiert man nun über alle Windungen der Abschirmspule (diese befinden sich näherungsweise alle auf dem gleichen Radius $R_2$) bekommt man neu folgende gegenseitige Kopplung der Störspule mit der Abschirmspule:

$$L_{2\leftarrow D} = L_{2\leftarrow D}^{cl} - \alpha \frac{Ra_1}{R_2} (L_{(2,\mathrm{red},Ra_1)\leftarrow D}^{cl} - L_{(2,\mathrm{red},Ri_1)\leftarrow D}^{cl})$$

$L_{(2,\mathrm{red},Ra1)\leftarrow D}^{cl}$ bezeichnet dabei die klassische Kopplung der Störspule mit der auf den Radius $Ra_1$ "reduzierten" Abschirmung (analog für $Ri_1$). Dieses "Reduzieren" zusammen mit dem Vorfaktor $Ra_1/R_2$ bewirkt, dass die Kopplung $L_{2\leftarrow D}$ gegenüber dem klassischen Wert $L_{2\leftarrow D}^{cl}$ verhältnismäßig viel weniger abgeschwächt wird als $L_{1\leftarrow D}$ gegenüber $L_{1\leftarrow D}^{cl}$. Da die Haupt- und die Abschirmspule elektrisch in Serie geschaltet sind, überwiegt deshalb in der Gesamtreaktion des Magnetspulensystems auf die Störung die induktive Reaktion der Abschirmspule gegenüber derjenigen der Hauptspule.
Insgesamt ist die neue Kopplung der Störung $D$ mit dem Magnetspulensystem $M$ gegeben durch

$$L_{M \leftarrow D} = L_{M \leftarrow D}^{cl} - \alpha L_{M \leftarrow D}^{cor} \qquad (5)$$

mit

$$L_{M \leftarrow D}^{cor} = L_{1 \leftarrow D}^{cl} - L_{(1,\text{red},Ri1) \leftarrow D}^{cl} + \frac{Ra_1}{R_2} (L_{(2,\text{red},Ra_1) \leftarrow D}^{cl} - L_{(2,\text{red},Ri_1) \leftarrow D}^{cl})$$

Analog wie bei der Hauptspule wird der Störfluss auch aus dem Supraleitervolumen der Abschirmung verdrängt. Weil aber dieses Volumen im Vergleich zum Supraleitervolumen der Hauptspule typischerweise klein ist, kann dieser Effekt vernachlässigt werden.

Ob das Störfeld durch eine Störspule innerhalb oder außerhalb der Magnetanordnung oder durch eine kleine Stromänderung im Magnetspulensystem selber erzeugt wird, ist für den Mechanismus der Flussverdrängung irrelevant. Aus diesem Grunde verändert sich auch die Eigeninduktivität des Magnetspulensystems im Vergleich zum klassischen Fall. Insbesondere gelten:

$$L_{1 \leftarrow 1} = (1 - \alpha)L_{1 \leftarrow 1}^{cl} + \alpha L_{(1,\text{red},Ri_1) \leftarrow 1}^{cl}$$

$$L_{1 \leftarrow 2} = (1 - \alpha)L_{1 \leftarrow 2}^{cl} + \alpha L_{(1,\text{red},Ri_1) \leftarrow 2}^{cl}$$

Die anderen Induktivitäten ändern sich wie folgt:

$$L_{2 \leftarrow 2} = L_{2 \leftarrow 2}^{cl} - \alpha \frac{Ra_1}{R_2} (L_{(2,\text{red},Ra_1) \leftarrow 2}^{cl} - L_{(2,\text{red},Ri_1) \leftarrow 2}^{cl})$$

$$L_{2 \leftarrow 1} = L_{2 \leftarrow 1}^{cl} - \alpha \frac{Ra_1}{R_2} (L_{(2,\text{red},Ra_1) \leftarrow 1}^{cl} - L_{(2,\text{red},Ri_1) \leftarrow 1}^{cl})$$

Insgesamt bekommt man für die neue Induktivität des Magnetspulensystems

$$L_M = L_M^{cl} - \alpha L_M^{cor} \qquad (6)$$

mit

$$L_M^{cor} = L_{1 \leftarrow 1}^{cl} - L_{(1,\text{red},Ri1) \leftarrow 1}^{cl} + L_{1 \leftarrow 2}^{cl} - L_{(1,\text{red},Ri1) \leftarrow 2}^{cl}$$

$$+ \frac{Ra_1}{R_2}(L_{(2,\text{red},Ra_1) \leftarrow 2}^{cl} - L_{(2,\text{red},Ri_1) \leftarrow 2}^{cl} + L_{(2,\text{red},Ra_1) \leftarrow 1}^{cl} - L_{(2,\text{red},Ri_1) \leftarrow 1}^{cl})$$

Setzt man in der Gleichung (1) für die effektive Feldeffizienz der Störspule $D$ die korrigierte Kopplung $L_{M \leftarrow D}$ von Magnet und Störspule gemäß Gleichung (5) anstelle der klassischen induktiven Kopplung $L_{M \leftarrow D}^{cl}$ und die korrigierte Eigeninduktivität $L_M$ gemäß Gleichung (6) anstelle der klassischen Eigeninduktivität $L_M^{cl}$ ein, so erhält man:

$$g_D^{eff} = g_D - g_M \cdot \frac{L_{M \leftarrow D}^{cl} - \alpha L_{M \leftarrow D}^{cor}}{L_M^{cl} - \alpha L_M^{cor}} \qquad (7)$$

Im Folgenden werden die obigen Formeln auf den Fall verallgemeinert, in dem noch zusätzliche Strompfade $P1,...,Pn$ vorhanden sind.

Für die Richtung $M \leftarrow Pj$ (eine Stromänderung in $Pj$ induziert einen Strom in $M$) sind die Kopplungen zwischen dem Magnetspulensystem und den zusätzlichen Strompfaden ($j = 1, ..., n$) in gleichem Maße reduziert wie die entsprechenden Kopplungen zwischen dem Magnetspulensystem und einer Störspule:

$$L_{M \leftarrow Pj} = L_{M \leftarrow Pj}^{cl} - \alpha L_{M \leftarrow Pj}^{cor} \tag{8}$$

wobei

$$L_{M \leftarrow Pj}^{cor} = L_{1 \leftarrow Pj}^{cl} - L_{(1,\mathrm{red},Ri_1) \leftarrow Pj}^{cl} + \frac{Ra_1}{R_2} (L_{(2,\mathrm{red},Ra_1) \leftarrow Pj}^{cl} - L_{(2,\mathrm{red},Ri_1) \leftarrow Pj}^{cl})$$

Die neue Kopplung $L_{Pj \leftarrow M}$ (eine Stromänderung in $M$ induziert einen Strom in $Pj$) berechnet sich hingegen wie folgt:

$$L_{Pj \leftarrow M} = L_{Pj \leftarrow M}^{cl} - \alpha L_{Pj \leftarrow M}^{cor}$$

mit

$$L_{Pj \leftarrow M}^{cor} = f_{Pj}(L_{(Pj,\mathrm{red},Ra_1) \leftarrow M}^{cl} - L_{(Pj,\mathrm{red},Ri_1) \leftarrow M}^{cl})$$

Für $R_{Pj} > Ra_1$ ist die auf $Ra_1$ "reduzierte" Spule $Pj$ wieder so definiert, dass alle Windungen auf den kleineren Radius $Ra_1$ komprimiert werden (analog für $Ri_1$). Ist hingegen $Ri_1 < R_{Pj} < Ra_1$, wird die auf $Ra_1$ "reduzierte" Spule mit der Spule $Pj$ identifiziert (die Windungen werden nicht expandiert auf $Ra_1$). Für $R_{Pj} < Ri_1$ wird auch die auf $Ri_1$ "reduzierte" Spule mit der Spule $Pj$ identifiziert, also ist in diesem Fall der Korrekturterm zur klassischen Theorie gleich null.
Für $R_{Pj} > Ra_1$ berechnet sich die Konstante $f_{Pj}$ aus der Integration von (4) über das Gebiet $r > R_{Pj}$. Für $R_{Pj} \leq Ra_1$ ist $f_{Pj} = 1$:

$$f_{Pj} = \begin{cases} \dfrac{Ra_1}{R_{Pj}}, & R_{Pj} > Ra_1 \\ 1, & R_{Pj} < Ra_1 \end{cases}$$

Die Korrekturen aufgrund der Eigenschaften des Supraleiters führen somit auf asymmetrische Induktivitätsmatrizen ($L_{M \leftarrow Pj} \neq L_{Pj \leftarrow M}$!).
Die Kopplung $L_{Pj \leftarrow D}$ zwischen einem zusätzlichen supraleitenden Strompfad $Pj$ und der Störspule $D$ wird ebenfalls mehr oder weniger stark von der Verdrängung des Flusses des Störfeldes der Spule $D$ aus dem Supraleitermaterial der Hauptspule beeinflusst:

$$L_{Pj \leftarrow D} = L_{Pj \leftarrow D}^{cl} - \alpha L_{Pj \leftarrow D}^{cor} \tag{10}$$

mit

$$L_{Pj \leftarrow D}^{cor} = f_{Pj} (L_{(Pj,\mathrm{red},Ra_1) \leftarrow D}^{cl} - L_{(Pj,\mathrm{red},Ri_1) \leftarrow D}^{cl})$$

Nach dem gleichen Prinzip werden auch die Kopplungen zwischen den zusätzlichen supraleitenden Strompfaden untereinander mehr oder weniger reduziert (man beachte dabei die Reihenfolge der Indizes):

$$L_{Pj \leftarrow Pk} = L^{cl}_{Pj \leftarrow Pk} - \alpha L^{cor}_{Pj \leftarrow Pk} \qquad (11)$$

mit

$$L^{cor}_{Pj \leftarrow Pk} = f_{Pj}(L^{cl}_{(Pj,\mathrm{red},Ra_1) \leftarrow Pk} - L^{cl}_{(Pj,\mathrm{red},Ri_1) \leftarrow Pk})$$

($j = 1, ..., n$; $k = 1, ..., n$).

Im Speziellen werden auch die Eigeninduktivitäten ($j = k$) der zusätzlichen supraleitenden Strompfade beeinflusst.

Der tatsächliche Feldbeitrag $g^{eff}_D$ pro Ampère Strom einer Störspule $D$ im Arbeitsvolumen wird berechnet mit der Gleichung (2) für die klassische Feldeffizienz $g^{eff,cl}_D$ der Störspule $D$, wobei die korrigierten Werte für die Kopplungen $L_{M \square D}$, $L_{M \square Pj}$, $L_{Pj \square M}$, $L_{Pj \square D}$ und $L_{Pj \square Pk}$ gemäß (5), (8), (9), (10) bzw. (11) eingesetzt werden:

$$g^{eff}_D = g_D - g^{\mathsf{T}} \cdot \left( L^{cl} - \alpha L^{cor} \right)^{-1} \cdot \left( L^{cl}_{\leftarrow D} - \alpha L^{cor}_{\leftarrow D} \right)$$

wobei:

$g^{eff}_D$ : Feldbeitrag pro Ampère Strom einer Störspule $D$ im Arbeitsvolumen bei $z = 0$ unter Berücksichtigung der Feldbeiträge der Störspule selbst wie auch der Feldänderung aufgrund von Strömen, welche im supraleitenden Magnetspulensystem $M$ und in den weiteren supraleitend geschlossenen Strompfaden $P1,...,Pn$ beim Laden der Störspule induziert werden,

$-\alpha$ : mittlere magnetische Suszeptibilität im Volumen des Magnetspulensystems $M$ gegenüber Feldfluktuationen, welche die Größenordnung von 0.1 T betragsmäßig nicht überschreiten; wobei $0 < \alpha \leq 1$,

$$g^{\mathsf{T}} = (g_M, g_{P1},...,g_{Pj},...g_{Pn}),$$

$g_{Pj}$ : Feld pro Ampère des Strompfades $Pj$ im Arbeitsvolumen ohne die Feldbeiträge der Strompfade $Pi$ für $i \neq j$ und des Magnetspulensystems $M$ und ohne die Feldbeiträge der Störspule $D$,

$g_M$ : Feld pro Ampère des Magnetspulensystems $M$ im Arbeitsvolumen ohne die Feldbeiträge der Strompfade $P1,...,Pn$ und ohne die Feldbeiträge der Störspule $D$,

$g_D$ : Feld pro Ampere der Störspule $D$ im Arbeitsvolumen ohne die Feldbeiträge der Strompfade $P1,...,Pn$ und des Magnetspulensystems $M$,

$L^{cl}$ : Matrix der induktiven Kopplungen zwischen dem Magnetspulensystem $M$ und den Strompfaden $P1,...,Pn$ sowie zwischen den Strompfaden $P1,...,Pn$ untereinander,

$L^{cor}$ : Korrektur zur Induktivitätsmatrix $L^{cl}$, welche sich bei kompletter diamagnetischer Verdrängung von Störfeldern aus dem Volumen des Magnetspulensystems $M$ ergäbe,

$L^{cl}_{\leftarrow D}$ : Vektor der induktiven Kopplungen der Störspule $D$ mit dem Magnetspulensystem $M$ und den Strompfaden $P1,...,Pn$,

$L^{cor}_{\leftarrow D}$ : Korrektur zum Kopplungsvektor $L^{cl}_{\leftarrow D}$, welche sich bei kompletter diamagnetischer Verdrängung von Störfeldern aus dem Volumen des Magnetspulensystems $M$ ergäbe.

Falls ein Strompfad $Pj$ Teilspulen auf unterschiedlichen Radien umfasst, müssen die Matrixelemente in den Korrekturtermen $L^{cor}$ und $L_{\leftarrow D}^{cor}$, welche zu $Pj$ gehören, so berechnet werden, dass zuerst jede Teilspule als einzelner Strompfad behandelt wird und dann die Korrekturterme aller Teilspulen aufaddiert werden. Diese Summe ist das Matrixelement des Strompfades $Pj$.

Um die Feldeffizienz $g_S^{eff}$ einer supraleitenden Shimvorrichtung $S$ zu berechnen, kann die oben hergeleitete Formel für $g_S^{eff}$ einer beliebigen Störspule $D$ benutzt werden, wobei an Stelle der Kopplungen des Magnetspulensystems $M$ und der zusätzlichen supraleitenden Strompfade $P1,...,Pn$ mit der Störspule $D$ jeweils die Kopplungen mit der Shimvorrichtung $S$ einzusetzen sind.

Die Feldeffizienz $g_S^{eff}$ einer supraleitenden Shimvorrichtung $S$ soll typischerweise im Wesentlichen null sein. Falls eine Shimvorrichtung im Arbeitsvolumen Feld erzeugt, führt das einerseits zu Problemen beim Shimvorgang selbst, andrerseits muss unter Umständen nach dem Einfahren des Shimstromes der Strom im Magnetspulensystem wieder angepasst werden, damit das Magnetfeld im Arbeitsvolumen wieder den Sollwert hat.

In vielen supraleitenden Magnetanordnungen $M, S, P1, ..., Pn$ mit einem Magnetspulensystem $M$, einer Shimvorrichtung $S$ und mit zusätzlichen supraleitend geschlossenen Strompfaden $P1, ..., Pn$ gibt es keinen großen Unterschied zwischen der klassisch berechneten Feldeffizienz $g_S^{eff,cl}$ und der nach der erfindungsgemäßen Methode berechneten Feldeffizienz $g_S^{eff}$. Eine Magnetanordnung, in welcher sich das magnetische Abschirmverhalten des Supraleitermaterials im Magnetspulensystem gegenüber kleinen Feldänderungen deutlich auf die Feldeffizienz $g_S^{eff}$ der Shimvorrichtung auswirkt, umfasst ein aktiv abgeschirmtes Magnetspulensystem mit einer Hauptspule $C1$ und einer Abschirmspule $C2$ sowie eine $Z^2$-Shimvorrichtung, deren Teilspulen auf zwei verschiedene Radien verteilt sind. Die radial innen liegenden Teilspulen der $Z^2$-Shimvorrichtung dienen vor allem dazu, ein Feld aufzubauen, welches entlang der Magnetachse $z$ eine quadratische $z$-Abhängigkeit aufweist. Mit den radial äußeren Teilspulen wird im Wesentlichen ein Feld erzeugt, welches entlang der $z$-Achse konstant ist. Mit diesem Feldbeitrag wird ein allfällig vorhandener konstanter Feldanteil der radial inneren Teilspulen kompensiert, so dass die Gesamtfeldeffizienz $g_S^{eff}$ der Shimvorrichtung im Arbeitsvolumen null ist. Typischerweise liegen die radial inneren Teilspulen der Shimvorrichtung im Bereich der Hauptspule $C1$ des aktiv abgeschirmten Magnetspulensystems und die radial äußeren Teilspulen im Bereich der Abschirmung $C2$. Der Vorteil einer so angeordneten Shimvorrichtung ist, dass sie kompakter ist verglichen mit einer Anordnung aus Teilspulen auf einem einzigen Radius und dass dadurch mehr Platz für das Magnetspulensystem zur Verfügung steht.

Aus den Figuren 2 bis 4 wird ersichtlich, dass sich Teilspulen einer Shimvorrichtung klassisch verhalten, solange sie sich im Bereich der Hauptspule $C1$ des aktiv abgeschirmten Magnetspulensystems befinden, dagegen wird ihre effektive Feldeffizienz durch das magnetische Abschirmverhalten des Supraleitermaterials im Magnetspulensystem verstärkt, wenn sie radial weiter außen liegen. Für das Beispiel der auf zwei Radien verteilten $Z^2$-Shimvorrichtung bedeutet dies, dass die effektive Feldeffizienz der radial außen liegenden Teilspulen größer ist, als nach dem klassischen Modell erwartet wird. Wenn eine solche Shimvorrichtung nach dem klassischen Modell dimensioniert wird (das heißt $g_S^{eff,cl} = 0$), wird also die tatsächliche effektive Feldeffizienz $g_S^{eff}$ deutlich von null abweichen.

Der Parameter $\alpha$ ist in einer ersten Näherung der Supraleiteranteil am Volumen der Hauptspule $C1$. Die genaueste Art, den Parameter $\alpha$ zu bestimmen, basiert auf einem Störexperiment des Magnetspulensystems $M$ ohne zusätzliche supraleitende Strompfade $S, P1, ..., Pn$. Störspulen mit großen Radien sind dafür besonders geeignet. Deshalb empfiehlt sich folgendes Vorgehen:

1. Experimentelle Bestimmung der Größe $\beta^{exp} = \dfrac{g_D^{exp}}{g_D}$ des Magnetspulensystems bezüglich einer im Bereich des Magnetspulensystems im Wesentlichen homogenen Störung (z.B. mit einer Störspule $D$ auf großem Radius), wobei

$g_D^{exp}$ :     gemessene Feldänderung im Arbeitsvolumen der Magnetanordnung pro Ampère Strom in der Störspule $D$,

$g_D$ :     Feld pro Ampere der Störspule $D$ im Arbeitsvolumen ohne die Feldbeiträge des Magnetspulensystems $M$,

2. Bestimmung der Größe

$$\beta^{cl} = 1 - g_M \cdot \left( \frac{L^{cl}_{M \leftarrow D}}{L^{cl}_M \cdot g_D} \right)$$

bezüglich derselben Störspule, wobei

$g_M$ : Feld pro Ampere des Magnetspulensystems $M$ im Arbeitsvolumen,

$L^{cl}_M$ : Induktivität des Magnetspulensystems $M$,

$L^{cl}_{M \leftarrow D}$ : induktive Kopplung der Störspule $D$ mit dem Magnetspulensystem $M$,

3. Bestimmung des Parameters $\alpha$ aus der Gleichung

$$\alpha = \frac{g_D (L^{cl}_M)^2 (\beta^{exp} - \beta^{cl})}{g_D (\beta^{exp} - \beta^{cl}) L^{cl}_M L^{cor}_M - g_M (L^{cl}_{M \leftarrow D} L^{cor}_M - L^{cor}_M \leftarrow L^{cl}_M)}.$$

wobei

$L^{cor}_M$ : Korrektur zur Magnetinduktivität $L^{cl}_M$, welche sich bei kompletter diamagnetischer Verdrängung von Störfeldern aus dem Volumen des Magnetspulensystems $M$ ergäbe,

$L^{cor}_{M \leftarrow D}$ : Korrektur zur induktiven Kopplung $L^{cl}_{M \leftarrow D}$ der Störspule $D$ mit dem Magnetspulensystem $M$, welche sich bei kompletter diamagnetischer Verdrängung von Störfeldern aus dem Volumen des Magnetspulensystems $M$ ergäbe.

**Patentansprüche**

**1.** Supraleitende Magnetanordnung ($M$, $S$, $P1$, ..., $Pn$) zur Erzeugung eines Magnetfeldes in Richtung einer $z$-Achse in einem um $z = 0$ angeordneten Arbeitsvolumen mit einem Magnetspulensystem (M) mit mindestens einer stromführenden supraleitenden Magnetspule, einer Shimvorrichtung (S) mit mindestens einer supraleitenden Shimspule und gegebenenfalls mit einem oder mehreren zusätzlichen supraleitend geschlossenen Strompfaden ($P1$, ..., $Pn$), wobei die durch die zusätzlichen Strompfade ($P1$, ..., $Pn$) im Betriebszustand aufgrund von induzierten Strömen erzeugten Magnetfelder in $z$-Richtung im Arbeitsvolumen die Größenordnung von 0.1 Tesla betragsmäßig nicht überschreiten, und wobei die Shimvorrichtung (S) ein Feld erzeugt, welches entlang der $z$-Achse mit der $k$-ten Potenz von $z$ variiert für eine gerade Zahl $k$ größer $0$,
**dadurch gekennzeichnet,**
**dass** die Shimvorrichtung (S) so ausgelegt ist, dass die Größe

$$g^{eff}_S = g_S - g^{\mathsf{T}} \cdot \left( L^{cl} - \alpha L^{cor} \right)^{-1} \cdot \left( L^{cl}_{\leftarrow S} - \alpha L^{cor}_{\leftarrow S} \right)$$

im Wesentlichen null ist und die Größe

$$g^{eff,cl}_S = g_S - g^{\mathsf{T}} \cdot (L^{cl})^{-1} \cdot L^{cl}_{\leftarrow S}$$

betragsmäßig größer als null ist, insbesondere größer als 0.2 Millitesla pro Ampère, wobei die genannten Größen folgende Bedeutung haben:

$-\alpha$ : mittlere magnetische Suszeptibilität im Volumen des Magnetspulensystems (M) gegenüber Feldfluktuationen, welche die Größenordnung von 0.1 T betragsmäßig nicht überschreiten; wobei $0 < \alpha \leq 1$,

$$g^{\mathrm{T}} = (g_M, g_{P1}, ..., g_{Pj}, ... g_{Pn}),$$

$g_{Pj}$ : Feld pro Ampere des Strompfades $Pj$ im Arbeitsvolumen ohne die Feldbeiträge der Strompfade $Pi$ für $i \neq j$ und des Magnetspulensystems (M) und ohne die Feldbeiträge der Shimvorrichtung (S),

$g_M$ : Feld pro Ampère des Magnetspulensystems (M) im Arbeitsvolumen ohne die Feldbeiträge der Strompfade ($P1,...,Pn$) und ohne die Feldbeiträge der Shimvorrichtung (S),

$g_S$ : Feld pro Ampère der Shimvorrichtung (S) im Arbeitsvolumen ohne die Feldbeiträge der Strompfade ($P1,...,Pn$) und des Magnetspulensystems (M),

$L^{cl}$ : Matrix der induktiven Kopplungen zwischen dem Magnetspulensystem (M) und den Strompfaden ($P1,..., Pn$) sowie zwischen den Strompfaden ($P1,...,Pn$) untereinander,

$L^{cor}$ : Korrektur zur Induktivitätsmatrix $L^{cl}$, welche sich bei kompletter diamagnetischer Verdrängung von Störfeldern aus dem Volumen des Magnetspulensystems (M) ergäbe,

$L^{cl}_{\leftarrow S}$ : Vektor der induktiven Kopplungen der Shimvorrichtung (S) mit dem Magnetspulensystem (M) und den Strompfaden ($P1,...,Pn$),

$L^{cor}_{\leftarrow S}$ : Korrektur zum Kopplungsvektor $L^{cl}_{\leftarrow S}$, welche sich bei kompletter diamagnetischer Verdrängung von Störfeldern aus dem Volumen des Magnetspulensystems (M) ergäbe.

2.  Magnetanordnung nach einem der vorangehenden Ansprüche, **dadurch gekennzeichnet, dass** das supraleitende Magnetspulensystem (M) ein radial inneres und ein radial äußeres, elektrisch in Serie zusammengeschaltetes, koaxiales Spulensystem ($C1$, $C2$) umfasst, wobei diese beiden Spulensysteme im Arbeitsvolumen je ein Magnetfeld mit entgegengesetzter Richtung entlang der $z$-Achse erzeugen.

3.  Magnetanordnung nach einem der vorhergehenden Ansprüche, **dadurch gekennzeichnet, dass** das Magnetspulensystem (M) einen ersten im Betriebszustand supraleitend kurzgeschlossenen Strompfad bildet, und dass eine mit dem Magnetspulensystem (M) galvanisch nicht verbundene Störkompensationsspule koaxial zu dem Magnetspulensystem (M) angeordnet ist und einen weiteren im Betriebszustand supraleitend kurzgeschlossenen Strompfad ($P1$) bildet.

4.  Magnetanordnung nach einem der vorhergehenden Ansprüche, **dadurch gekennzeichnet, dass** mindestens einer der zusätzlichen Strompfade ($P1, ..., Pn$) aus einem mit einem supraleitenden Schalter überbrückten Teil des Magnetspulensystems (M) besteht.

5.  Magnetanordnung nach einem der vorhergehenden Ansprüche, **dadurch gekennzeichnet, dass** die supraleitende Shimvorrichtung (S) ein Feld erzeugt, welches auf der $z$-Achse im Bereich des Arbeitsvolumens eine quadratische $z$-Abhängigkeit aufweist.

6.  Magnetanordnung nach einem der vorhergehenden Ansprüche, **dadurch gekennzeichnet, dass** die supraleitende Shimvorrichtung (S) Teilspulen umfasst, welche auf unterschiedlichen Radien gewickelt sind.

7.  Magnetanordnung nach einem der vorhergehenden Ansprüche, **dadurch gekennzeichnet, dass** die supraleitende Shimvorrichtung (S) vom supraleitenden Magnetspulensystem (M) induktiv entkoppelt ist.

8.  Apparatus zur hochauflösenden Magnetresonanzspektroskopie, enthaltend eine Magnetanordnung nach einem der vorangehenden Ansprüche.

9.  Verfahren zur Dimensionierung der supraleitenden Shimvorrichtung (S) in einer Magnetanordnung nach einem der Ansprüche 1-7, **dadurch gekennzeichnet, dass** die Größe $g_S^{eff}$, welche der Feldänderung im Arbeitsvolumen bei $z = 0$ pro Ampère Strom in der Shimvorrichtung (S) entspricht, unter Berücksichtigung der aufgrund von in der restlichen Magnetanordnung (*M, P1, ..., Pn*) induzierten Strömen erzeugten Magnetfelder, berechnet wird gemäß:

$$g_S^{eff} = g_S - g^{\mathsf{T}} \cdot \left(L^{cl} - \alpha L^{cor}\right)^{-1} \cdot \left(L_{\leftarrow S}^{cl} - \alpha L_{\leftarrow S}^{cor}\right),$$

wobei die genannten Größen folgende Bedeutung haben:

$-\alpha$ :  mittlere magnetische Suszeptibilität im Volumen des Magnetspulensystems (M) gegenüber Feldfluktuationen, welche die Größenordnung von 0.1 T betragsmäßig nicht überschreiten; wobei $0 < \alpha \le 1$

$$g^{\mathsf{T}} = (g_M, g_{P1}, ..., g_{Pj}, ... g_{Pn}),$$

$g_{Pj}$ :  Feld pro Ampère des Strompfades *Pj* im Arbeitsvolumen ohne die Feldbeiträge der Strompfade *Pi* für $i \ne j$ und des Magnetspulensystems (M) und ohne die Feldbeiträge der Shimvorrichtung (S),

$g_M$ :  Feld pro Ampere des Magnetspulensystems (M) im Arbeitsvolumen ohne die Feldbeiträge der Strompfade (*P1,...,Pn*) und ohne die Feldbeiträge der Shimvorrichtung (S),

$g_S$ :  Feld pro Ampère der Shimvorrichtung (S) im Arbeitsvolumen ohne die Feldbeiträge der Strompfade (*P1,..., Pn*) und des Magnetspulensystems (M),

$L^{cl}$ :  Matrix der induktiven Kopplungen zwischen dem Magnetspulensystem (M) und den Strompfaden (*P1,..., Pn*) sowie zwischen den Strompfaden (*P1,...,Pn*) untereinander,

$L^{cor}$ :  Korrektur zur Induktivitätsmatrix $L^{cl}$, welche sich bei kompletter diamagnetischer Verdrängung von Störfeldern aus dem Volumen des Magnetspulensystems (M) ergäbe,

$L_{\leftarrow S}^{cl}$ :  Vektor der induktiven Kopplungen der Shimvorrichtung (S) mit dem Magnetspulensystem (M) und den Strompfaden (*P1,...,Pn*),

$L_{\leftarrow S}^{cor}$ :  Korrektur zum Kopplungsvektor $L_{\leftarrow S}^{cl}$, welche sich bei kompletter diamagnetischer Verdrängung von Störfeldern aus dem Volumen des Magnetspulensystems (M) ergäbe.

**10.** Verfahren nach Anspruch 9, **dadurch gekennzeichnet, dass** der Parameter $\alpha$ experimentell bestimmt wird aus der Messung der Größe $\beta^{exp}$ des Magnetspulensystems (M) ohne Strompfade (*P1,...,Pn*) und ohne Shimvorrichtung (S) bezüglich einer Störspule (*D*), welche im Volumen des Magnetspulensystems (*M*) im Wesentlichen ein homogenes Störfeld erzeugt, und durch Einsetzen der Größe $\beta^{exp}$ in die Gleichung

$$\alpha = \frac{g_D (L_M^{cl})^2 (\beta^{exp} - \beta^{cl})}{g_D (\beta^{exp} - \beta^{cl}) L_M^{cl} L_M^{cor} - g_M (L_{M \leftarrow D}^{cl} L_M^{cor} - L_M^{cor} \leftarrow L_M^{cl})}.$$

wobei

$$\beta^{exp} = \frac{g_D^{exp}}{g_D},$$

$g_D^{exp}$ :  gemessene Feldänderung im Arbeitsvolumen der Magnetanordnung pro Ampere Strom in der Störspule (*D*),

$$\beta^{cl} = 1 - g_M \cdot \left( \frac{L^{cl}_{M \leftarrow D}}{L^{cl}_M \cdot g_D} \right),$$

$g_M$ :      Feld pro Ampere des Magnetspulensystems (*M*) im Arbeitsvolumen,

$g_D$ :      Feld pro Ampère der Störspule (*D*) im Arbeitsvolumen ohne die Feldbeiträge des Magnetspulensystems (M),

$L^{cl}_M$ :      Induktivität des Magnetspulensystems (M),

$L^{cl}_{M \leftarrow D}$ :      induktive Kopplung der Störspule (*D*) mit dem Magnetspulensystem (M),

$L^{cor}_M$ :      Korrektur zur Magnetinduktivität $L^{cl}_M$, welche sich bei kompletter diamagnetischer Verdrängung von Störfeldern aus dem Volumen des Magnetspulensystems (M) ergäbe,

$L^{cor}_{M \leftarrow D}$ :      Korrektur zur induktiven Kopplung $L^{cl}_{M \leftarrow D}$ der Störspule (*D*) mit dem Magnetspulensystem (M), welche sich bei kompletter diamagnetischer Verdrängung von Störfeldern aus dem Volumen des Magnetspulensystems (M) ergäbe.

## Claims

**1.** Superconducting magnet arrangement (*M, S, P1, ..., Pn*) for generating a magnetic field in a direction of a z axis in a working volume disposed about *z* = 0, comprising a magnet coil system (M) with at least one current-carrying superconducting magnet coil, a shim device (S) with at least one superconducting shim coil and optionally one or more additional superconductingly closed current paths (*P1, ..., Pn*), wherein the absolute values of the magnetic fields in the z direction in the working volume generated by the additional current paths (*P1, ..., Pn*) due to induced currents do not exceed the magnitude of 0.1 Tesla, and wherein the shim device (S) generates a field which varies along the z axis with the kth power of z for an even number of k larger than 0,
**characterized in that**
the shim device (S) is designed such that the variable

$$g_S^{eff} = g_S - g^{\mathrm{T}} \cdot \left( L^{cl} - \alpha L^{cor} \right)^{-1} \cdot \left( L^{cl}_{\leftarrow S} - \alpha L^{cor}_{\leftarrow S} \right)$$

is substantially zero and the absolute value of the variable

$$g_S^{eff,cl} = g_S - g^{\mathrm{T}} \cdot \left( L^{cl} \right)^{-1} \cdot L^{cl}_{\leftarrow S}$$

is larger than zero, in particular larger than 0.2 millitesla per ampere, wherein said variables have the following definitions:

$-\alpha$ :      average magnetic susceptibility in the volume of the magnet coil system (M) with respect to field fluctuations the absolute values of which do not exceed a magnitude of 0.1 T, wherein $0 < \alpha \leq 1$,

$$g^{\mathrm{T}} = (g_M, g_{P1}, ..., g_{Pj}, ..., g_{Pn}),$$

$g_{Pj}$ :      Field per ampere of the current path *Pj* in the working volume without the field contributions of the current paths *Pi* for $i \neq j$, of the magnet coil system (M), and without the field contributions of the shim device (S),

$g_M$ :      Field per ampere of the magnet coil system (M) in the working volume without the field contributions of the current paths (*P1,...,Pn*) and without the field contributions of the shim device (S),

$g_S$ :      Field per ampere of the shim device (S) in the working volume without the field contributions of the current paths (*P1,...,Pn*) and of the magnet coil system (M),

$L^{cl}$ :      Matrix of the inductive couplings between the magnet coil system (M) and the current paths (*P1,...,Pn*) and among the current paths (*P1,...,Pn*),

$L^{cor}$ :      Correction for the inductance matrix $L^{cl}$ , which would result with complete diamagnetic expulsion of disturbance fields from the volume of the magnet coil system (M),

$L^{cl}_{\leftarrow S}$ :      Vector of the inductive couplings of the shim device (S) with the magnet coil system (M) and the current paths (*P1,...,Pn*),

$L^{cor}_{\leftarrow S}$ :      Correction for the coupling vector $L^{cl}_{\leftarrow S}$, which would result with complete diamagnetic expulsion of disturbance fields from the volume of the magnet coil system (M).

2. Magnet arrangement according to any one of the preceding claims, **characterized in that** the superconducting magnet coil system (M) comprises a radially inner and a radially outer coaxial coil system (*C1*, *C2*) which are electrically connected in series, wherein these two coil systems each generate a magnetic field of opposing direction along the z axis in the working volume.

3. Magnet arrangement according to any one of the preceding claims, **characterized in that** the magnet coil system (M) forms a first current path which is superconductingly short circuited during operation, and that a disturbance compensation coil which is not galvanically connected to the magnet coil system (M) is disposed coaxially to the magnet coil system (M) to form a further current path (*P1*) which is superconductingly short-circuited during operation.

4. Magnet arrangement according to any one of the preceding claims, **characterized in that** at least one of the additional current paths (*P1, ..., Pn*) consists of a part of the magnet coil system (M) which is bridged with a superconducting switch.

5. Magnet arrangement according to any one of the preceding claims, **characterized in that** the superconducting shim device (S) generates a field which has a quadratic z dependence on the z axis in the region of the working volume.

6. Magnet arrangement according to any one of the preceding claims, **characterized in that** the superconducting shim device (S) comprises partial coils which are wound on different radii.

7. Magnet arrangement according to any one of the preceding claims, **characterized in that** the superconducting shim device (S) is inductively decoupled from the superconducting magnet coil system (M).

8. Apparatus for high-resolution magnetic resonance spectroscopy comprising a magnet arrangement according to any one of the preceding claims.

9. Method for dimensioning the superconducting shim device (S) in a magnet arrangement according to any one of the claims 1 to 7, **characterized in that** the variable $g^{eff}_S$ , which corresponds to the field change in the working volume at z = 0 per ampere current in the shim device (S) is calculated taking into consideration the magnetic fields generated by the currents induced in the remaining magnet arrangement (*M, P1, ..., Pn*):

$$g^{eff}_S = g_S - g^{\mathrm{T}} \cdot \left( L^{cl} - \alpha L^{cor} \right)^{-1} \cdot \left( L^{cl}_{\leftarrow S} - \alpha L^{cor}_{\leftarrow S} \right),$$

wherein the mentioned variables have the following definitions:

-α:      average magnetic susceptibility in the volume of the magnet coil system (M) with respect to field fluctuations the absolute values of which do not exceed a magnitude of 0.1 T, wherein $0 < \alpha \leq 1$,

$$g^{\mathrm{T}} = (g_M, g_{P1}, ..., g_{Pj}, ..., g_{Pn}),$$

$g_{Pj}$ : Field per ampere of the current path $Pj$ in the working volume without the field contributions of the current paths $Pi$ for $i \neq j$ and of the magnet coil system (M) and without the field contributions of the shim device (S),

$g_M$ : Field per ampere of the magnet coil system (M) in the working volume without the field contributions of the current paths $(P1,...,Pn)$ and without the field contributions of the shim device (S),

$g_S$ : Field per ampere of the shim device (S) in the working volume without the field contributions of the current paths $(P1,...,Pn)$ and of the magnet coil system (M),

$L^{cl}$ : Matrix of the inductive couplings between the magnet coil system (M) and the current paths $(P1,...,Pn)$ and among the current paths $(P1,...,Pn)$,

$L^{cor}$ : Correction for the inductance matrix $L^{cl}$, which would result with complete diamagnetic expulsion of disturbance fields from the volume of the magnet coil system (M),

$L^{cl}_{\leftarrow S}$ : Vector of the inductive couplings of the shim device (S) with the magnet coil system (M) and the current paths $(P1,...,Pn)$,

$L^{cor}_{\leftarrow S}$ : Correction for the coupling vector $L^{cl}_{\leftarrow S}$, which would result with complete diamagnetic expulsion of disturbance fields from the volume of the magnet coil system (M).

**10.** Method according to claim 9, **characterized in that** the parameter $\alpha$ is experimentally determined from measurement of a variable $\beta^{exp}$ of the magnet coil system (M) without the current paths $(P1,...,Pn)$ and without the shim device (S) with respect to a disturbance coil (D), which generates substantially a homogeneous disturbance field in the volume of the magnet coil system *(M)* and through insertion of the variable $\beta^{exp}$ into the equation

$$\alpha = \frac{g_D (L^{cl}_M)^2 (\beta^{exp} - \beta^{cl})}{g_D (\beta^{exp} - \beta^{cl}) L^{cl}_M L^{cor}_M - g_M (L^{cl}_{M \leftarrow D} L^{cor}_M - L^{cor}_{M \leftarrow D} L^{cl}_M)} \ ,$$

wherein

$$\beta^{exp} = \frac{g^{exp}_D}{g_D} \ ,$$

$g^{exp}_D$ : Measured field change in the working volume of the magnet arrangement per ampere current in the disturbance coil (D),

$$\beta^{cl} = 1 - g_M \cdot \left( \frac{L^{cl}_{M \leftarrow D}}{L^{cl}_M \cdot g_D} \right) \ ,$$

$g_M$ : Field per ampere of the magnet coil system *(M)* in the working volume,

$g_D$ : Field per ampere of the disturbance coil (D) in the working volume without the field contributions of the magnet coil system (M),

$L^{cl}_M$ : Inductance of the magnet coil system (M),

$L^{cl}_{M \leftarrow D}$ : Inductive coupling of the disturbance coil (D) with the magnet coil system (M),

$L^{cor}_M$ : Correction for the magnetic inductance $L^{cl}_M$, which would result with complete diamagnetic expulsion of disturbance fields from the volume of the magnet coil system (M),

$L^{cor}_{M \leftarrow D}$ : Correction for the inductive coupling $L^{cl}_{M \leftarrow D}$ of the disturbance coil (D) with the magnet coil system (M), which would result with complete diamagnetic expulsion of disturbance fields from the volume of the magnet coil system (M).

**Revendications**

1. Agencement magnétique supraconducteur (*M*, *S*, *P1*, ... *Pn*) pour générer un champ magnétique en direction d'un axe *z* dans un volume de travail situé autour de *z* = 0, comprenant un système de bobines magnétiques (M) avec au moins une bobine magnétique supraconductrice parcourue par du courant, un dispositif de shim (S) avec au moins une bobine de shim supraconductrice et le cas échéant avec un ou plusieurs trajets de courant (*P1*, ..., *Pn*) fermés de manière supraconductrice supplémentaires, dans lequel les champs magnétiques créés en fonctionnement par les trajets de courant (*P1*, ..., *Pn*) supplémentaires en raison des courants induits ne dépassent pas en valeur l'ordre de grandeur de 0,1 tesla en direction *z* dans le volume de travail, et dans lequel le dispositif de shim (S) génère un champ qui varie le long de l'axe *z* avec la *k*ième puissance de *z* pour un nombre *k* pair supérieur à 0,

   **caractérisé par le fait**
   **que** le dispositif de shim (S) est dimensionné de telle manière que la grandeur

$$g_S^{eff} = g_S - g^T \cdot (L^{cl} - \alpha L^{cor})^{-1} \cdot (L_{\leftarrow S}^{cl} - \alpha L_{\leftarrow S}^{cor})$$

   soit essentiellement nulle et que la grandeur

$$g_S^{eff,cl} = g_S - g^T \cdot (L^{cl})^{-1} \cdot L_{\leftarrow S}^{cl}$$

   soit supérieure à zéro en valeur, en particulier supérieure à 0,2 millitesla par ampère, les grandeurs mentionnées ayant la signification suivante :

   - $-\alpha$ : susceptibilité magnétique moyenne dans le volume du système de bobines magnétiques (M) par rapport à des fluctuations de champ qui ne dépassent pas en valeur l'ordre de grandeur de 0,1 T ; avec $0 < \alpha \le 1$,

$$g^T = (g_M, g_{P1}, ..., g_{Pj}, ... g_{Pn})$$

   $g_{Pj}$ : champ par ampère du trajet de courant *Pj* dans le volume de travail sans les contributions au champ des trajets de courant *Pi* pour $i \ne j$ et du système de bobines magnétiques (M) et sans les contributions au champ du dispositif de shim (S),

   $g_M$ : champ par ampère du système de bobines magnétiques (M) dans le volume de travail sans les contributions au champ des trajets de courant (*P1,..., Pn*) et sans les contributions au champ du dispositif de shim (S),

   $g_S$ : champ par ampère du dispositif de shim (S) dans le volume de travail sans les contributions au champ des trajets de courant (*P1,..., Pn*) et du système de bobines magnétiques (M),

   $L^{cl}$ : matrice des couplages inductifs entre le système de bobines magnétiques (M) et les trajets de courant (*P1,..., Pn*) ainsi qu'entre les trajets de courant (*P1,..., Pn*) entre eux,

   $L^{cor}$ : correction à la matrice d'inductances $L^{cl}$ que l'on obtiendrait en cas de refoulement diamagnétique complet des champs perturbateurs du volume du système de bobines magnétiques (M),

   $L_{\leftarrow S}^{cl}$ : vecteur des couplages inductifs du dispositif de shim (S) avec le système de bobines magnétiques (M) et les trajets de courant (*P1,..., Pn*),

   $L_{\leftarrow S}^{cor}$ : correction au vecteur de couplage $L_{\leftarrow S}^{cl}$ que l'on obtiendrait en cas de refoulement diamagnétique complet des champs perturbateurs du volume du système de bobines magnétiques (M).

2. Agencement magnétique selon la revendication précédente,
   **caractérisé par le fait que** le système de bobines magnétiques (M) supraconductrices comprend deux systèmes de bobines coaxiaux (C1, C2), l'un radialement intérieur et l'autre radialement extérieur, interconnectés électriquement en série, ces deux systèmes de bobines générant dans le volume de travail des champs magnétiques de sens opposés le long de l'axe *z*.

3. Agencement magnétique selon l'une des revendications précédentes,
   **caractérisé par le fait que** le système de bobines magnétiques (M) forme un premier trajet de courant court-circuité de manière supraconductrice en fonctionnement et qu'une bobine compensatrice de perturbation, non reliée électriquement au système de bobines magnétiques (M), est disposée coaxialement au système de bobines magnétiques (M) et forme un autre trajet de courant court-circuité de manière supraconductrice (*P1*) en fonctionnement.

**4.** Agencement magnétique selon l'une des revendications précédentes,
**caractérisé par le fait qu'**au moins un des trajets de courant supplémentaires (*P1*, ..., *Pn*) est constitué d'une partie du système de bobines magnétiques (M) shuntée par un commutateur supraconducteur.

**5.** Agencement magnétique selon l'une des revendications précédentes,
**caractérisé par le fait que** le dispositif de shim (S) supraconducteur génère un champ qui présente une dépendance quadratique de *z* sur l'axe *z* au niveau du volume de travail.

**6.** Agencement magnétique selon l'une des revendications précédentes,
**caractérisé par le fait que** le dispositif de shim supraconducteur (S) comprend des bobines partielles qui sont enroulées sur des rayons différents.

**7.** Agencement magnétique selon l'une des revendications précédentes,
**caractérisé par le fait que** le dispositif de shim supraconducteur (S) est découplé inductivement du système de bobines magnétiques (M) supraconductrices.

**8.** Appareil pour la spectroscopie par résonance magnétique à haute résolution contenant un agencement magnétique selon l'une des revendications précédentes.

**9.** Procédé pour dimensionner le dispositif de shim supraconducteur (S) dans un agencement magnétique selon l'une des revendications 1 à 7, **caractérisé par le fait que** la grandeur $g_S^{eff}$, qui correspond à la variation de champ dans le volume de travail à $z = 0$ par ampère de courant dans le dispositif de shim (S), est calculée, compte tenu des champs magnétiques créés en raison des courants induits dans le reste de l'agencement magnétique (*M, P1, ..., Pn*), par la formule :

$$g_S^{eff} = g_S - g^T \cdot (L^{cl} - \alpha L^{cor})^{-1} \cdot (L_{\leftarrow S}^{cl} - \alpha L_{\leftarrow S}^{cor})$$

dans laquelle les grandeurs mentionnées ont la signification suivante :

-$\alpha$ : susceptibilité magnétique moyenne dans le volume du système de bobines magnétiques (M) par rapport à des fluctuations de champ qui ne dépassent pas en valeur l'ordre de grandeur de 0,1 T ; $0 < \alpha \le 1$,

$$g^T = (g_M, g_{P1}, ..., g_{Pj}, ... g_{Pn})$$

$g_{Pj}$ : champ par ampère du trajet de courant *Pj* dans le volume de travail sans les contributions au champ des trajets de courant *Pi* pour $i \ne j$ et du système de bobines magnétiques (M) et sans les contributions au champ du dispositif de shim (S),

$g_M$ : champ par ampère du système de bobines magnétiques (M) dans le volume de travail sans les contributions au champ des trajets de courant (*P1,..., Pn*) et sans les contributions au champ du dispositif de shim (S),

$g_S$ : champ par ampère du dispositif de shim (S) dans le volume de travail sans les contributions au champ des trajets de courant (*P1,..., Pn*) et du système de bobines magnétiques (M),

$L^{cl}$ : matrice des couplages inductifs entre le système de bobines magnétiques (M) et les trajets de courant (*P1,..., Pn*) ainsi qu'entre les trajets de courant (*P1,..., Pn*) entre eux,

$L^{cor}$ : correction à la matrice d'inductances $L^{cl}$ que l'on obtiendrait en cas de refoulement diamagnétique complet des champs perturbateurs du volume du système de bobines magnétiques (M),

$L_{\leftarrow S}^{cl}$ : vecteur des couplages inductifs du dispositif de shim (S) avec le système de bobines magnétiques (M) et les trajets de courant (*P1,..., Pn*),

$L_{\leftarrow S}^{cor}$ : correction au vecteur de couplage $L_{\leftarrow S}^{cl}$ que l'on obtiendrait en cas de refoulement diamagnétique complet des champs perturbateurs du volume du système de bobines magnétiques (M).

**10.** Procédé selon la revendication 9, **caractérisé par le fait que** le paramètre $\alpha$ est déterminé expérimentalement à partir de la mesure de la grandeur $\beta^{exp}$ du système de bobines magnétiques (M) sans les trajets de courant (*P1,..., Pn*) et sans dispositif de shim (S) en relation avec une bobine perturbatrice (D) qui génère dans le volume du système de bobines magnétiques (M) un champ perturbateur essentiellement homogène et en introduisant la grandeur $\beta^{exp}$ dans l'équation :

$$\alpha = \frac{g_D(L_M^{cl})^2(\beta^{exp} - \beta^{cl})}{g_D(\beta^{exp} - \beta^{cl})L_M^{cl}L_M^{cor} - g_M(L_{M\leftarrow D}^{cl}L_M^{cor} - L_{M\leftarrow D}^{cor}L_M^{cl})}.$$

dans laquelle

$$\beta^{exp} = \frac{g_D^{exp}}{g_D},$$

$g_D^{exp}$ : variation de champ mesurée dans le volume de travail de l'agencement magnétique par ampère de courant dans la bobine perturbatrice (D),

$$\beta^{cl} = 1 - g_M \cdot \left( \frac{L_{M\leftarrow D}^{cl}}{L_M^{cl} \cdot g_D} \right),$$

$g_M$ : champ par ampère du système de bobines magnétiques (M) dans le volume de travail,

$g_D$ : champ par ampère de la bobine perturbatrice (D) dans le volume de travail sans les contributions au champ du système de bobines magnétiques (M),

$L_M^{cl}$ : inductance du système de bobines magnétiques (M),

$L_{M\leftarrow D}^{cl}$ : couplage inductif de la bobine perturbatrice (D) avec le système de bobines magnétiques (M),

$L_M^{cor}$ : correction à l'inductance magnétique $L_M^{cl}$ que l'on obtiendrait en cas de refoulement diamagnétique complet des champs perturbateurs du volume du système de bobines magnétiques (M),

$L_{M\leftarrow D}^{cor}$ : correction au couplage inductif $L_{M\leftarrow D}^{cl}$ de la bobine perturbatrice (D) avec le système de bobines magnétiques (M) que l'on obtiendrait en cas de refoulement diamagnétique complet des champs perturbateurs du volume du système de bobines magnétiques (M).

Fig. 1

Fig. 2

Fig. 3

Fig. 4